# EUROPEAN PATENT APPLICATION

(11) **EP 4 672 318 A2**
(43) Date of publication of application: **31.12.2025**
(21) Application number: 25172498.5
(22) Date of filing: 25.04.2025
(51) Int. Cl.: H01L 23/15, H01L 23/538, H01L 25/16, H01L 21/48

(54) **DISAGGREGATED PACKAGE SUBSTRATES WITH GLASS CORES**

(30) Priority: 27.06.2024 US 202418756580
(71) Applicant: INTEL Corporation, Santa Clara, CA 95054 (US)
(72) Inventor: Ecton, Jeremy, Gilbert AZ, 85298 (US); Duan, Gang, Chandler AZ, 85248 (US); Kaplan, Jefferson Coker, Chandler AZ, 85226 (US); Brandon Christian, Marin, Gilbert AZ, 85234 (US); Pietambaram, Srinivas Venkata Ramanuja, Chandler AZ, 85249 (US)
(74) Representative: Samson & Partner Patentanwälte mbB

(57) **Abstract**

Disaggregated package substrates with glass cores are disclosed. An example package substrate includes a glass core having a first side and a second side opposite the first side. The example package substrate further includes a first block of redistribution layers on the first side of the glass core. The example package substrate also includes a second block of redistribution layers on the first side of the glass core. The first block is distinct from the second block.

## Description

### BACKGROUND

In many electronic devices, semiconductor chips and/or dies (e.g., integrated circuit (IC) chips) are connected to larger circuit boards such as motherboards and/or other types of printed circuit boards (PCBs). Frequently, the IC chips are contained within a package that includes a package substrate with one or more redistribution layers containing metal interconnects that enable electrical connections between contacts on the IC chips and corresponding contacts on PCBs.

### BRIEF DESCRIPTION OF THE DRAWINGS

FIG. 1 illustrates an example integrated circuit (IC) package constructed in accordance with teachings disclosed herein.
FIGS. 2-6 illustrate different stages of fabrication in an example process to fabricate a first implementation of the example IC package of FIG. 1.
FIG. 7 illustrates another example IC package that is modified relative to the IC package of FIG. 6.
FIG. 8 illustrates an example IC package corresponding to another example implementation of the example IC package of FIG. 1.
FIGS. 9-11 illustrate different stages in a fabrication process to connect example redistribution blocks to a glass core through hybrid bonding.
FIGS. 12-16 illustrate different stages of fabrication in an example process to fabricate another implementation of the example IC package of FIG. 1.
FIGS. 17-24 illustrate different stages of fabrication in another example process to fabricate another implementation of the example IC package of FIG. 1.
FIGS. 25-28 illustrate different stages of fabrication in another example process to fabricate another example IC package in accordance with teachings disclosed herein.
FIG. 29 illustrates another example IC package constructed in accordance with teachings disclosed herein.
FIG. 30 illustrates another example IC package constructed in accordance with teachings disclosed herein.
FIG. 31 is a flowchart representative of an example method that may be performed to fabricate any one of the example IC packages of FIGS. 1-24.
FIG. 32 is a flowchart representative of an example method that may be performed to fabricate any one of the example IC packages of FIGS. 25-30.
FIG. 33 is a top view of a wafer including dies that may be included in an IC package constructed in accordance with teachings disclosed herein.
FIG. 34 is a cross-sectional side view of an IC device that may be included in an IC package constructed in accordance with teachings disclosed herein.
FIG. 35 is a cross-sectional side view of an IC device assembly that may include an IC package constructed in accordance with teachings disclosed herein.
FIG. 36 is a block diagram of an example electrical device that may include an IC package constructed in accordance with teachings disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

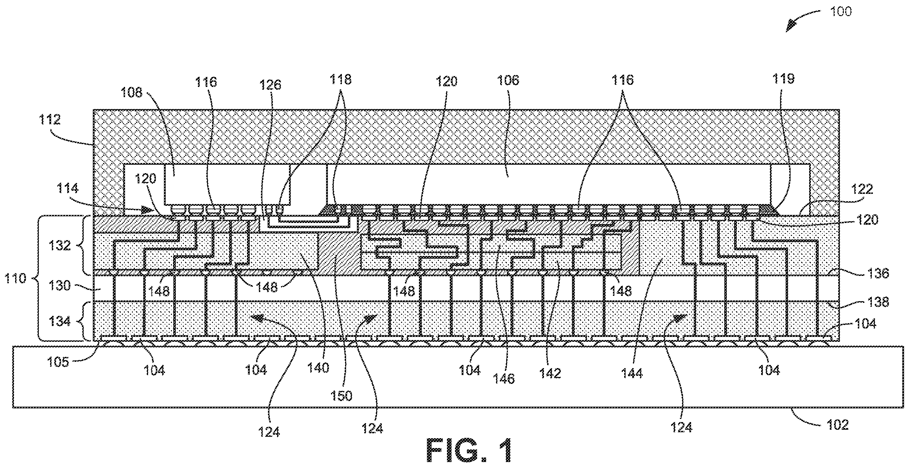

FIG. 1 illustrates an example integrated circuit (IC) package 100 constructed in accordance with teachings disclosed herein. In the illustrated example, the IC package 100 is electrically coupled to a circuit board 102 via an array of contact pads or lands 104 on a mounting surface 105 (e.g., a bottom surface) of the package. In some examples, the IC package 100 may include balls, pins, and/or pads, in addition to or instead of the contact pads 104, to enable the electrical coupling of the package 100 to the circuit board 102. In this example, the package 100 includes two semiconductor (e.g., silicon) dies 106, 108 (sometimes also referred to as chips or chiplets) that are mounted to a package substrate 110 and enclosed by a package lid or mold compound 112. Thus, the package substrate 110 is an example means for supporting a semiconductor die. While the example IC package 100 of FIG. 1 includes two dies 106, 108, in other examples, the package 100 may have only one die or more than two dies. In some examples, one of the dies 106, 108 (or a separate die) is embedded in the package substrate 110. The dies 106, 108 can provide any suitable type of functionality (e.g., data processing, memory storage, etc.).

As shown in the illustrated example, each of the dies 106, 108 is electrically and mechanically coupled to the substrate 110 via corresponding arrays of interconnects 114. In FIG. 1, the interconnects are shown as bumps. However, the interconnects 114 may be any other type of electrical connection in addition to or instead of the bumps shown (e.g., balls, pins, pads, wire bonding, etc.). The electrical connections between the dies 106, 108 and the substrate 110 (e.g., the interconnects 114) are sometimes referred to as first level interconnects. By contrast, the electrical connections between the IC package 100 and the circuit board 102 (e.g., the pads 104) are sometimes referred to as second level interconnects. In some examples, one or both of the dies 106, 108 may be stacked on top of one or more other dies and/or an interposer. In such examples, the dies 106, 108 are coupled to the underlying die and/or interposer through a first set of first level interconnects and the underlying die and/or interposer may be connected to the package substrate 110 via a separate set of first level interconnects associated with the underlying die and/or interposer. Thus, as used herein, first level interconnects refer to interconnects (e.g., balls, bumps, pins, pads, wire bonding, etc.) between a die and a package substrate or a die and an underlying die and/or interposer.

As shown in FIG. 1, the interconnects 114 of the first level interconnects include two different types of bumps corresponding to core bumps 116 and bridge bumps 118. As used herein, the core bumps 116 are bumps on the dies 106, 108 through which electrical signals pass between the dies 106, 108 and components external to the IC package 100. More particularly, as shown in the illustrated example, when the dies 106, 108 are mounted to the package substrate 110, the core bumps 116 are physically connected and electrically coupled to contact pads 120 on an inner surface 122 of the substrate 110. The contact pads 120 on the inner surface 122 of the package substrate 110 are electrically coupled to the landing pads 104 on the bottom (external) surface 105 of the substrate 110 (e.g., a surface opposite the inner surface 122) via internal interconnects 124 within the substrate 110. As a result, there is a continuous electrical signal path between the bumps 116 of the dies 106, 108 and the landing pads 104 mounted to the circuit board 102 that pass through the contact pads 120 and the interconnects 124 provided therebetween.

As used herein, the bridge bumps 118 are bumps on the dies 106, 108 through which electrical signals pass between different ones of the dies 106, 108 within the package 100. Thus, as shown in the illustrated example, the bridge bumps 118 of the first die 106 are electrically coupled to the bridge bumps 118 of the second die 108 via an interconnect die 126 (e.g., interconnect bridge) embedded in the package substrate 110. As represented in FIG. 1, core bumps 116 are typically larger than bridge bumps 118. In some examples, the interconnect bridge 126 and the associated bridge bumps 118 are omitted.

In some examples, an underfill material 119 is disposed between the dies 106, 108 and the package substrate 110 around and/or between the first level interconnects 114 (e.g., around and/or between the core bumps 116 and/or the bridge bumps 118). In the illustrated example, only the first die 106 is associated with the underfill material 119. However, in other examples, both dies 106, 108 are associated with the underfill material 119. In other examples, the underfill material 119 is omitted. In some examples, the mold compound 112 is used as an underfill material that surrounds the first level interconnects 114.

In some examples, the IC package 100 includes additional passive components, such as surface-mount resistors, capacitors, and/or inductors disposed on the bottom (external) surface 105 of the package substrate 110 and/or on the top (inner) surface 122 of the package substrate 110.

In FIG. 1, the substrate 110 of the example IC package 100 includes a glass substrate, layer, or core 130 between first and second build-up layers or regions 132, 134 and respective first and second sides or surfaces 136, 138 of the core 130. In some examples, the core 130 includes at least one of: alumino silicate, borosilicate, alumino-borosilicate, silica, and/or fused silica. In some examples, the core 130 includes one or more additives including: aluminum oxide (Al₂O₃), boron trioxide (B₂O₃), magnesia oxide (MgO), calcium oxide (CaO), stoichiometric silicon oxide (SiO), barium oxide (BaO), stannic oxide (SnO₂), nickel alloy (Na₂O), potassium oxide (K₂O), phosphorus trioxide (P₂O₃), zirconium dioxide (ZrO₂), lithium oxide (Li₂O), titanium (Ti), and/or zinc (Zn). In some examples, the core 130 includes silicon and oxygen. In some examples, the core 130 includes silicon, oxygen and/or one or more of aluminum, boron, magnesium, calcium, barium, tin, sodium, potassium, strontium, phosphorus, zirconium, lithium, titanium, and/or zinc. In some examples, the core 130 includes at least 23 percent silicon by weight and at least 26 percent oxygen by weight. In some examples, the glass core is a layer of glass including silicon, oxygen and aluminum. In some examples, the core 130 includes at least 23 percent silicon by weight, at least 26 percent oxygen by weight, and at least 5 percent aluminum by weight.

In some examples, the glass core 130 is an amorphous solid glass layer. In some examples, the core 130 is a layer of glass that does not include an organic adhesive or an organic material. In some examples, the core 130 is a solid layer of glass having a rectangular shape in plan view. In some examples, the core 130, as a glass substrate, includes at least one glass layer and does not include epoxy and does not include glass fibers (e.g., does not include an epoxy-based prepreg layer with glass cloth). In some examples, the core 130 corresponds to a single piece of glass that extends the full height/thickness of the core. In other examples, the core 130 can be silicon, a dielectric material, and/or any other material(s). In some examples, the core 130 has a rectangular shape that is substantially coextensive, in plan view, with the layers (e.g., the build-up regions 132, 134) above and/or below the core.

In some examples, the core 130 has a thickness in a range of about 50 micrometers (µm) to about 1.4 millimeters (mm). In some examples, the core 130 can be a multi-layer glass substrate (e.g., a coreless substrate), where a glass layer has a thickness in a range of about 25 µm to about 50 µm. In some examples, the core 130 can have dimensions of about 10 mm on a side to about 250 mm on a side (e.g., 10 mm by 10 mm to 250 mm by 250 mm). In some examples, the core 130 corresponds to a rectangular prism volume with sections (e.g., vias) removed and filled with other materials (e.g., metal). Among other things, glass cores are advantageous over epoxy-based cores because glass is stiffer and, therefore, provides for greater mechanical support or strength for the package substrate. Thus, the glass core 130 is an example means for strengthening the package substrate. Although examples disclosed herein are described as including glass cores, teachings disclosed herein can also be applied to other types of cores (e.g., epoxy-based cores). That is, in some examples, the glass core 130 is replaced with an organic and/or epoxy-based core (e.g., an epoxy-based prepreg layer with glass cloth) and/or any other suitable type of substrate core.

As shown in the illustrated example of FIG. 1, the first build-up region 132 includes multiple disaggregated sections or blocks 140, 142, 144, 146 that are discrete and separate from one another. The blocks 140, 142, 144, 146 are distinct blocks of dielectric material with metal interconnects provided therein that define portions of the interconnects 124 that extend through the package substrate 110. That is, the blocks 140, 142, 144, 146 function as redistribution layers for portions or segments of the first build-up region 132. Accordingly, the blocks 140, 142, 144, 146 are referred to herein as blocks of redistribution layers or simply, redistribution blocks for short. The redistribution blocks 140, 142, 144, 146 are disaggregated from one another and from the core 130. As used herein, the term disaggregated means separate or independent of one another. In other words, disaggregated means physically decoupled from one another at the completion of the fabrication of each disaggregated component. Thus, the physical and/or electrically coupling of disaggregated components involves additional process operations (subsequent to their individual fabrication) to attach or combine them together. In some examples, the disaggregated redistribution blocks 140, 142, 144, 146 may be fabricated at the same time on the same substrate and subsequently singulated or cut into separate and independent (i.e., disaggregated) blocks. That is, in some examples, disaggregated redistribution blocks are separate and independent at the end of a fabrication process of the different blocks without necessarily being separate (physically decoupled) during fabrication. In other examples, the disaggregated redistribution blocks 140, 142, 144, 146 and the core 130 may be fabricated at separate times and/or at separate locations and/or using separate processes such that the blocks are separate and independent (e.g., physically decoupled from one another) both during the fabrication process and at the end the fabrication process of the different blocks. Regardless of the processes of fabrication employed, the disaggregated (e.g., separate and independent) redistribution blocks 140, 142, 144, 146 and the core 130 may be subsequently connected together into a unitary package. Combining disaggregated components in this manner does not change the fact that the components are disaggregated because, as explained above, the combining of the components depends upon additional processes of attachment or mounting that are distinct from and follow after the processes used to initially fabricate the different components.

Fabricating the disaggregated redistribution blocks 140, 142, 144, 146 separate from one another and then combining them together to define the complete first build-up region 132 is a different approach to fabricating build-up regions for a package substrate from what has been done in the past. Typically, build-up regions are fabricated in-situ on the core one layer at a time. That is, known techniques for package substrate fabrication include successively adding alternating layers of dielectric material and metal across the entire surface of the core. Each successive metal layer is patterned to define traces, wiring, contact pads, and/or routing at that layer and the different metal layers are electrically coupled by metal vias extending through the intervening dielectric layers. This known approach to fabricating package substrates presents several challenges. For example, as the number of interconnects to be provided through a package substrate increases (generally associated with a corresponding increase in size of the substrate), the chance for a defect in the substrate increases. As a result, relatively large package substrates are often associated with relatively large yield losses. Further, while glass cores provide certain benefits over epoxy-based cores, fabricating build-up regions directly on a glass core imposes limitations on the types of a fabrication processes that can be used because of the relatively fragile nature of glass as compared with epoxy-based cores.

Examples disclosed herein overcome or at least partially mitigate these concerns by disaggregating the redistribution blocks 140, 142, 144, 146 from one another and from the glass core 130. In some examples, the redistribution blocks 140, 142, 144, 146 are fabricated by adding alternating layers of dielectric material and layers of conductive material (e.g., a metal such as copper) on top of each other. However, in some disclosed examples, the alternating layers of dielectric material and metal for different ones of the blocks 140, 142, 144, 146 are fabricated independent of one another and/or singulated into separate and independent blocks physically decoupled from one another and physically decoupled from the core 130 when initially fabricated. By disaggregating the first build-up region 132 of FIG. 1 into multiple discrete redistribution blocks 140, 142, 144, 146, each block can be tested individually to confirm there are no defects before being consolidated into the build-up region 132. That is, in some examples, only known good blocks are included in the first build-up region 132. While individual blocks will occasionally be defective, the likelihood of this occurring is relatively small because of the smaller size of the blocks relative to the full size of the build-up region 132. Furthermore, when such defects occur, the amount of material that must be discarded (e.g., the defective redistribution block) is much less than having to discard a full package substrate found to be defective. Thus, examples disclosed herein can significantly save on costs and improve yield losses.

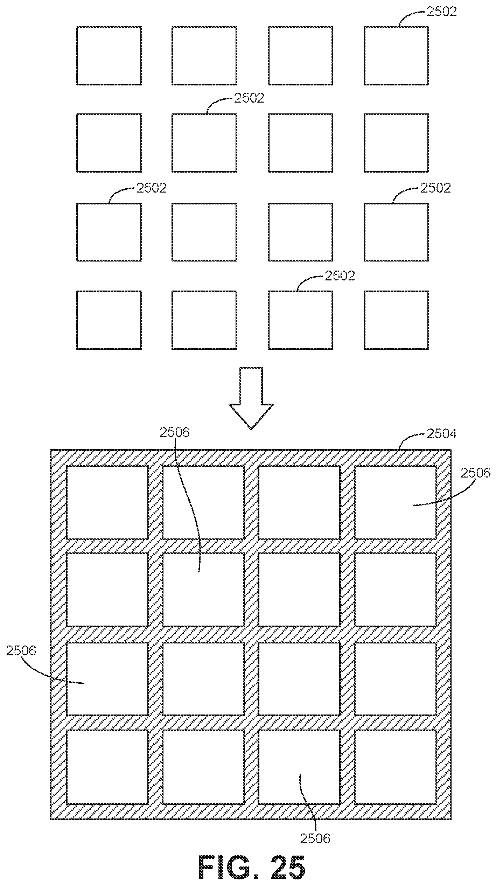

Additionally, by disaggregating the redistribution blocks 140, 142, 144, 146 from the core 130, examples disclosed herein enable greater options in the types of fabrication processes that can be used. For instance, by fabricating the redistribution blocks 140, 142, 144, 146 independent of the glass core 130 (e.g., before connecting the blocks to the core), processes that may risk damage to the glass core 130 without special (costly) handling can be easily (cost effectively) implemented for the redistribution blocks 140, 142, 144, 146. Thus, certain structures and/or package designs can be achieved more efficiently and/or cost effectively than is otherwise possible using known techniques with glass cores. Additionally or alternatively, similar benefits can be achieved by encasing, encapsulating, and/or surrounding the glass core 130 with an organic material to protect the glass core 130 during subsequent processing. That is, in some examples, the glass core is positioned within a window or opening of an organic frame and then enclosed by an organic mold compound (e.g., epoxy). Protecting a glass core in this manner can facilitate the handling of the glass core so that processes that would otherwise not be suitable with an unprotected glass core become available for use. This approach, with an organic frame around the glass core 130, is not represented in FIG. 1 but is detailed further below in connection with FIGS. 25-30.

Due to the disaggregation (e.g., the physically decoupled nature) of the redistribution blocks 140, 142, 144, 146 and the glass core 130, the blocks 140, 142, 144, 146 are attached to the core 130 during a later process (e.g., after the individual blocks and the core have been fabricated). In some examples, the redistribution blocks 140, 142, 144, 146 are attached to the core 130 using die mounting techniques. For instance, as shown in FIG. 1, the first and second redistribution blocks 140, 142 are attached to the glass core 130 using solder bumps 148 (e.g., micro-bumps) that electrically and mechanically connect with through glass vias (TGVs) in the glass core 130. In some examples, this solder bonding process includes thermal compression bonding. Although the bumps 148 are shown as being smaller than the bumps 116, 118 on the dies 106, 108, in some examples, the bumps 148 connecting the redistribution blocks 140, 142 to the glass core 130 can be as large as or larger than the bumps 116, 118.

Additionally or alternatively, as represented in FIG. 1, the third redistribution block 144 is attached to the glass core 130 via hybrid bonding. Hybrid bonding may also be referred to as direct bonding. That is, in this example, the mounting surface (e.g., bottom surface in FIG. 1) of the third block 144 directly interfaces with the glass core 130 (e.g., directly abuts the first surface 136) so that the interfacing metal (e.g., copper) in third block 144 and the core 130 forms direct fusion bonds. Further, in some such examples, the mounting surface of the third redistribution block 144 includes glass that fusion bonds with the material of the glass core 130 surrounding the TGVs. While the first and second redistribution blocks 140, 142 are shown as connected to the glass core 130 using solder and the third redistribution block 144 is connected by hybrid bonding, other arrangements are possible. For instance, in some examples, all of the redistribution blocks 140, 142, 144 are connected to the glass core 130 using solder. In other examples, all of the redistribution blocks 140, 142, 144 are connected to the glass core 130 via hybrid bonding. More generally, any (or all) of the blocks 140, 142, 144, 146 can be connected to the glass core 130 using a first mounting technique and any of the other blocks can be connected using any other suitable mounting technique(s).

In some examples, different ones of the redistribution blocks 140, 142, 144, 146 are laterally adjacent one another along the first surface 136 of the glass core 130. That is, the blocks 140, 142, 144, 146 are distributed across the first surface 136 to cover or overlap with different portions or areas of the glass core 130. Additionally or alternatively, in some examples, the redistribution blocks 140, 142, 144, 146 can be stacked on top of one another in a direction normal to the first surface 136 of the core 130, as represented by the second and fourth blocks 142, 146. In this example, the fourth redistribution block 146 can be mounted or attached to the second block in a similar manner in which the first, second, and/or third blocks 140, 142, 144 are attached to the glass core 130 (e.g., using solder, by direct hybrid (e.g., fusion) bonds, etc.). In some examples, all of the redistribution blocks 140, 142, 144, 146 are laterally distributed without any being stacked on one another. In other examples, all of the redistribution blocks 140, 142, 144, 146 can be stacked on one another without any being lateral adjacent to one another. In other examples, some are stacked and others are laterally adjacent.

In some examples, the laterally adjacent redistribution blocks 140, 142, 144, 146 are spaced apart from one another. In some such examples, a filler material 150 fills the gap(s) or space(s) between the adjacent redistribution blocks 140, 142, 144, 146. In some examples, the filler material 150 is implemented by a mold compound (e.g., epoxy). In other examples, the filler material 150 is implemented by a liquid dielectric and/or underfill (e.g., capillary underfill, etc.). In some examples, the filler material 150 may extend over a top surface of the blocks 140, 142, 144, 146 (e.g., a surface opposite the surface facing the glass core 130). In some such examples, additional redistribution layer(s) (e.g., metal interconnects) may be defined or provided in the filler material 150 to complete the signal path along the interconnects 124 up to the contact pads 120 on the inner surface 122 of the package substrate 110. This is represented by the portion of the metal interconnects 124 in the area above the first and fourth redistribution blocks 140, 146 shown in FIG. 1. In other examples, the redistribution blocks 140, 142, 144, 146 can extend up to and/or define a portion of the inner surface 122. That is, in some examples, the filler material 150 does not extend over the top surface of the blocks, as in the case of the third block 144 shown in FIG. 1. In some examples, additional redistribution layer(s) can be added over the redistribution blocks 140, 142, 144, 146 using standard build-up layer fabrication techniques, regardless of whether the filler material 150 extends over any of the redistribution blocks 140, 142, 144, 146. That is, in some examples, after attaching the redistribution blocks 140, 142, 144, 146 to the glass core 130 and filling any gaps with the filler material 150, one or more layers of an epoxy-based dielectric material can be laminated across the entire surface of the first build-up region 132 with interleaving metal layers to further define the first build-up region 132 and further construct the interconnects 124.

Although four separate redistribution blocks 140, 142, 144, 146 are shown in FIG. 1, any suitable number of redistribution blocks may be implemented (e.g., 1, 2, 3, 4, 6, 8, 10, 12, etc.). For instance, in some examples, the first build-up region 132 includes only a single disaggregated redistribution block. In some such examples, the single disaggregated redistribution block is the same size as (e.g., overlaps or covers an entirety of, has the same footprint as) the glass core 130. Although the redistribution block is the same size as the glass core 130 in such examples, the block may still be fabricated separate (e.g., physically decoupled) from glass core 130 and attached subsequently to such fabrication (rather than being fabricated directly on the glass core 130).

For purposes of simplicity and clarity, separate redistribution blocks are not shown in the second build-up region 134 of FIG. 1. However, in some examples, the second build-up region 134 also includes one or more disaggregated redistribution blocks. In some examples, only one of the build-up regions 132, 134 includes disaggregated redistribution block(s) while the other is fabricated directly on the glass core 130 using standard techniques.

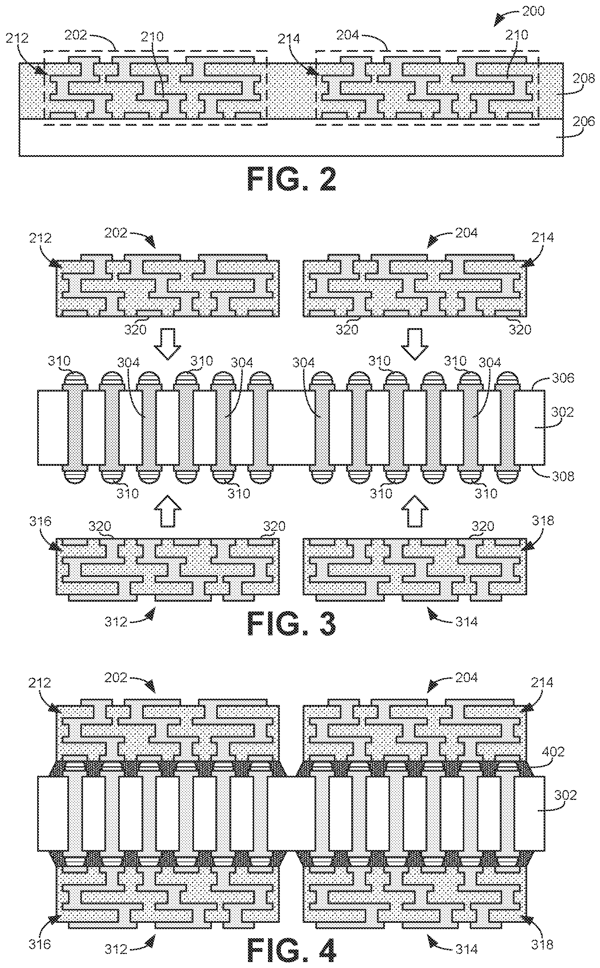

FIGS. 2-6 illustrate different stages of fabrication in an example process to fabricate a first implementation of the example IC package 100 of FIG. 1. Specifically, FIG. 2 represents an example redistribution block wafer or panel 200 from which individual (e.g., first and second) redistribution blocks 202, 204 may be produced. The example first and second redistribution blocks 202, 204 can correspond to any of the redistribution blocks 140, 142, 144, 146 in FIG. 1. In this example, the first and second redistribution blocks 202, 204 are fabricated on a carrier 206 using any suitable processes used in fabricating redistribution layers or build-up layers in a package substrate. Thus, in some examples, alternating layers of dielectric material 208 (e.g., an organic epoxy laminate) and layers of metal 210 (e.g., copper) are deposited (e.g., laminated) across the carrier 206 and the layers of metal 210 are patterned to define traces, wiring, contact pads, and/or routing in each layer. Further, conductive vias are added to extend through the intervening dielectric layers to electrical couple the traces, wiring, contact pads, and/or routing in the separate metal layers to complete interconnects 212, 214 constructed to extend through the individual redistribution blocks 202, 204. In FIG. 2, the interconnects 212, 214 fabricated for each of the first and second redistribution blocks 202, 204 are shown to have the same shape or design. However, in some examples, the shape, design, and/or constructions of the interconnects 212 in the first redistribution block 202 can be different from the interconnects 214 in the second redistribution block 204.

As shown in the illustrated example of FIG. 2, the different redistribution blocks 202, 204 are fabricated side-by-side in the same layer(s) of the dielectric material 208 that extend across the entire surface of the carrier 206. In such examples, the individual redistribution blocks 202, 204 are subsequently separated from one another (e.g., via singulation), which is why the blocks 202, 204 are identified in FIG. 2 by dashed boxes. The redistribution blocks 202, 204 in isolated form (e.g., after singulation) are shown in FIG. 3. In other examples, the different redistribution blocks 202, 204 are fabricated spaced apart from one another on the carrier 206. That is, in some examples, the dielectric material 208 may not extend across the entire surface of the carrier 206 (e.g., between the different redistribution blocks 202, 204). In other examples, the different redistribution blocks 202, 204 are fabricated completely independent of one another on separate carriers 206. Regardless of the relationship of the redistribution blocks 202, 204 during fabrication, they end up as completely separate (e.g., disaggregated) blocks of dielectric material 208 containing metal interconnects (e.g., the interconnects 212, 214).

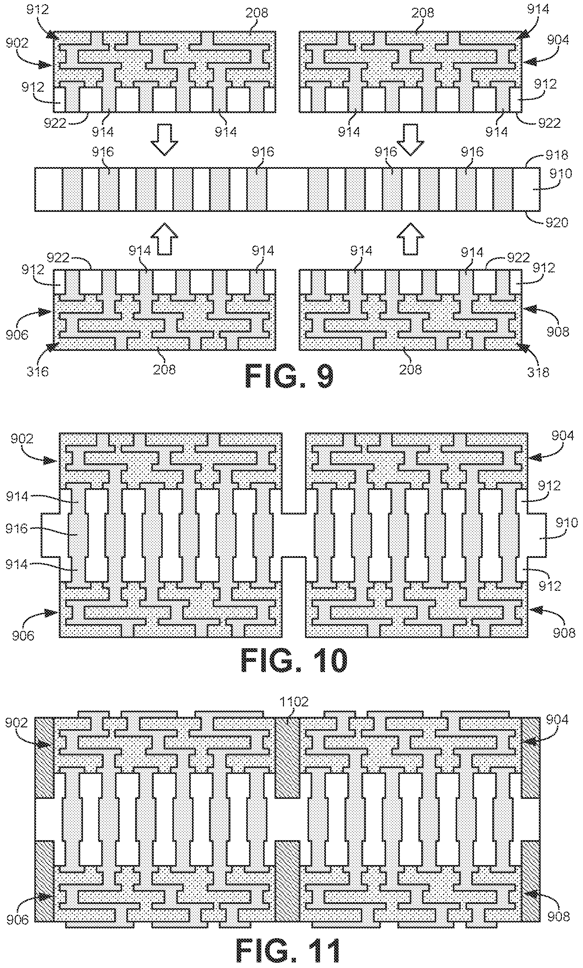

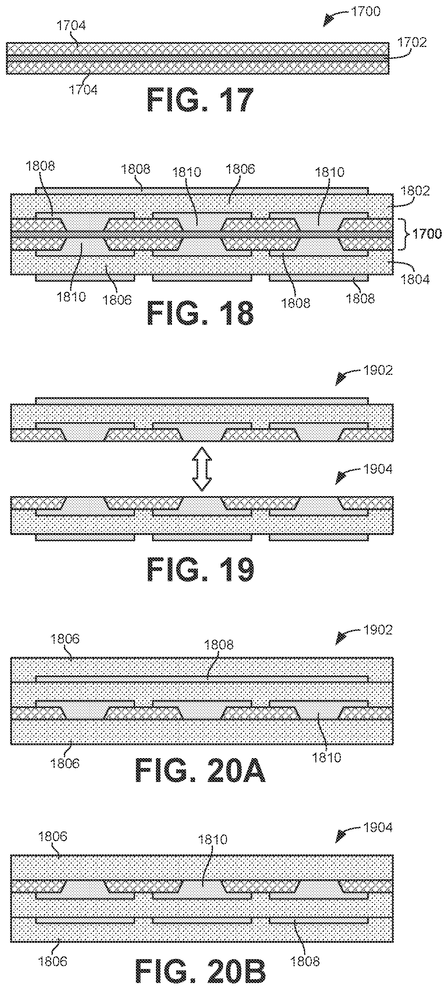

In some examples, the carrier 206 is a sacrificial carrier meaning that the carrier 206 is not part of the redistribution blocks 202, 204 used in subsequent fabrication processes. Rather, the carrier 206 merely serves as a substrate to facilitate the initial fabrication of the redistribution blocks 202, 204. In other words, the carrier 206 provides rigidity and stability to fabricate the redistribution blocks 202, 204 without a separate core as is commonly employed in known package substrates. That is, the example redistribution blocks 202, 204 are coreless redistribution blocks (once they are fully fabricated and isolated from one another and the carrier 206). Inasmuch as the carrier 206 is sacrificial, the carrier 206 can be composed of any suitable material (e.g., an organic material, a semiconductor material, a glass or other ceramic material, etc.). In some examples, the redistribution blocks 202, 204 can be fabricated in other ways that do not use the carrier 206. For instance, in some examples, the different redistribution blocks 202, 204 are fabricated on a glass base that is retained as part of the redistribution blocks 202, 204 after singulation. An example of this approach is detailed further below in connection with FIGS. 9-11. In other examples, the different coreless redistribution blocks 202, 204 are fabricated on opposing sides of a peelable central core and then subsequently separated from the central core. An example of this approach is detailed further below in connection with FIGS. 17-24.

FIG. 3 represents the individual redistribution blocks 202, 204 being transferred (e.g., via a pick-and-place process) to a glass core 302 that has already gone through several fabrication processes. More particularly, at the stage of fabrication shown in FIG. 3, the glass core 302 has already been provided with a plurality of through glass vias (TGVs) 304 that extend between opposite sides 306, 308 (e.g., opposite surfaces) of the glass core 302. Further, in this example, solder bumps 310 have been added to contact pads at each end of the TGVs 304 along both sides 306, 308 of the glass core 302. The example glass core 302 can correspond to the example glass core 130 in FIG. 1.

In the illustrated example of FIG. 3, the individual blocks 202, 204 from FIG. 2 are transferred to the same first side 306 of the glass core 302 with two other (e.g., third and fourth) redistribution blocks 312, 314 being transferred to the other side. In this example, the third and fourth redistribution blocks 312, 314 have similar interconnects 316, 318 to the first and second redistribution blocks 202, 204. However, in some examples, the construction, design, and/or layout of at least some of the interconnects 212, 214, 316, 318 differs from one another. In some examples, the third and fourth redistribution blocks 312, 314 are fabricated on the same carrier 206 shown above in FIG. 2. In other examples, the third and fourth redistribution blocks 312, 314 are fabricated on a different carrier. In some examples, each of the redistribution blocks 202, 204, 312, 314 are fabricated on different carriers. In other words, whether the redistribution blocks 202, 204, 312, 314 are fabricated at the same time or different times and/or fabricate on the same carrier or different carriers is irrelevant because the redistribution blocks 202, 204, 312, 314 are eventually separated and/or isolated from one another, which is what makes them disaggregated redistribution blocks.

Although disaggregated, the separate redistribution blocks 202, 204, 312, 314 are reconstituted together by being transferred to the glass core 302, as shown in FIG. 3. More particularly, in this example, each of the redistribution blocks 202, 204, 312, 314 includes an array of contact pads 320 distributed across the surface facing towards the glass core 302 that correspond with (e.g., align with) the solder bumps 310. Thus, in this example, the redistribution blocks 202, 204, 312, 314 are attached (e.g., mounted) to the glass core 130 through a thermal compression bonding process with the solder of the solder bumps 310 electrically coupling the interconnects 212, 214, 316, 318 in the redistribution blocks 202, 204, 312, 314 with the TGVs 304 in the glass core 302 as shown in FIG. 4. FIG. 4 also represents the subsequent application of an underfill material 402 between the redistribution blocks 202, 204, 312, 314 and the glass core 302 to extend around and between the different solder connections. In some examples, the underfill material 402 is omitted.

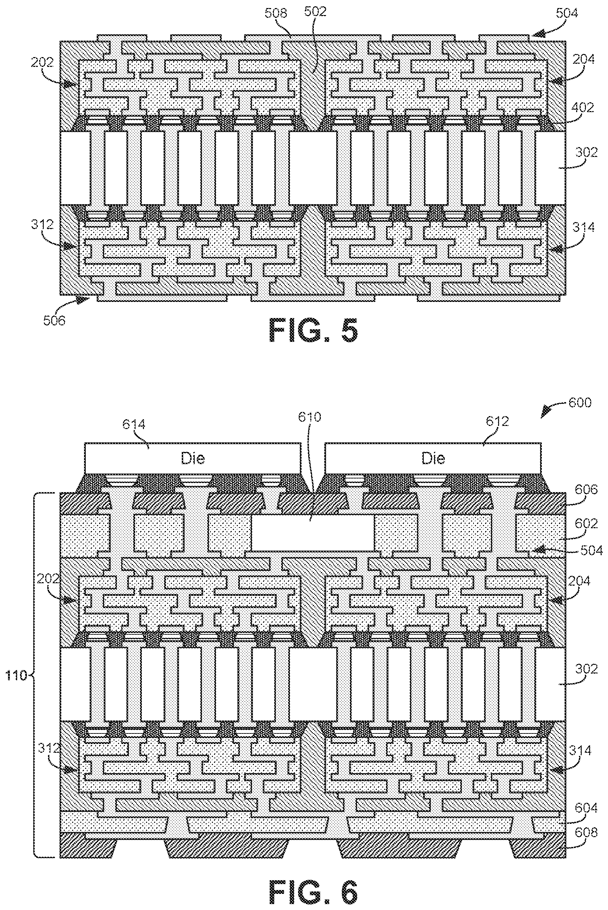

FIG. 5 represents the completion of the reconstitution of the disaggregated redistribution blocks 202, 204, 312, 314 onto the glass core 302 through the deposition of a filler material 502 (e.g., a mold compound, an epoxy, a liquid dielectric, an underfill, or other encapsulant) to fill the gaps between and/or encapsulate (e.g., enclose) the redistribution blocks 202, 204, 312, 314 and the glass core 302. In some examples, the filler material 502 can serve the function of and fill the space corresponding to the underfill material 402. In some examples, one or more additional redistribution layer(s) 504, 506 can be patterned in and/or on the filler material 502 to define electrical connections between the adjacent redistribution blocks 202, 204, 312, 314 and/or to define traces, wires, contact pads, and/or routing that is to connect with additional layers in the build-up regions 132, 134. That is, as shown in the illustrated example, the additional redistribution layer 504 includes a trace 508 that is distinct and spaced apart from both the first and second redistribution blocks 202, 204, and that connects corresponding interconnects in the first and second redistribution blocks 202, 204. In this example, both the first and second redistribution blocks 202, 204 are closer to the glass core 302 than the trace 508 is to the glass core 302.

More generally, at this stage in the process, any suitable additional fabrication processes can be implemented to complete the fabrication of the package substrate (e.g., the substrate 110 of FIG. 1) to which one or more dies (e.g., the dies 106, 108 of FIG. 1) may be mounted. Specifically, as shown in the illustrated example of FIG. 6, one or more additional layers of dielectric material 602, 604 (e.g., an organic epoxy laminate) are added to each side of the glass core 302 that are then capped with solder resist layers 606, 608. Further, metal vias are defined through the layers of dielectric material 602, 604 to be electrically coupled to contacts on the exterior surfaces of the package substrate 110 (e.g., the landing pads 104 on the mounting surface 105 in FIG. 1 and the contact pads 120 on the inner surface 122 in FIG. 1). In the illustrated example, the metal vias extend directly through the upper additional layers of dielectric material 602 without redistribution, whereas the metal vias in the lower additional layers of dielectric material 604 are connected to traces and/or other routing such that the lower layers 604 function as a redistribution layer. In other examples, the upper layers 602 may include traces and/or other routing to function as a redistribution layer in addition to or instead of the lower layers 604. Likewise, in some examples, the lower layers 604 may not include traces and/or other routing and, instead, be implemented similar to what is shown for the upper layers 602. As shown in the illustrated example, although the redistribution blocks 202, 204, 312, 314 are smaller than the glass core 302 so as to overlap with limited portions of the glass core 302, the additional layers of dielectric material 602, 604 can extend across the entire package substrate (e.g., overlap with an entire footprint of the glass core 302). Further, as shown in the illustrated example, the additional layer of dielectric material 602 extends across or over both the first and second redistribution blocks 202, 204. That is, in this example, both the first and second redistribution blocks 202, 204 are between the glass core 302 and the layer of dielectric material 602. In some examples, the additional redistribution layer(s) 504, 506 and/or the additional layers of dielectric material 602, 604 may be omitted. That is, in some examples, the outer metal layer on the redistribution blocks 202, 204, 312, 314 defines the landing pads 104 on the mounting surface 105 in FIG. 1 and/or the contact pads 120 on the inner surface 122 in FIG. 1.

In some examples, as shown in FIG. 6, the additional layer of dielectric material 602 includes an interconnect die 610 (e.g., an interconnect bridge), which may correspond to the interconnect die 126 of FIG. 1. In this example, the interconnect die 610 is a silicon interconnect bridge (e.g., an embedded multi-die interconnect bridge (EMIB)) that provides electrical connections between first and second dies 612, 614 entirely within the interconnect die 610. In other examples, the interconnect die 610 is implemented with organic material such as an organic polymer. The example IC package 600 is an example implementation of the example IC package 100 of FIG. 1, with the first and second dies 612, 614 corresponding to the first and second dies 106, 108 of FIG. 1.

In FIG. 6, the redistribution blocks 202, 204, 312, 314 are shown as being approximately the same size (e.g., having a same width) as the dies 612, 614. However, in other examples, the redistribution blocks 202, 204, 312, 314 can be larger than the dies 612, 614. In other examples, the redistribution blocks 202, 204, 312, 314 are smaller than the dies 612, 614. Further, in some examples, different ones of the redistribution blocks 202, 204, 312, 314 are different sizes (e.g., some larger than the dies 612, 614 and some smaller than the dies 612, 614).

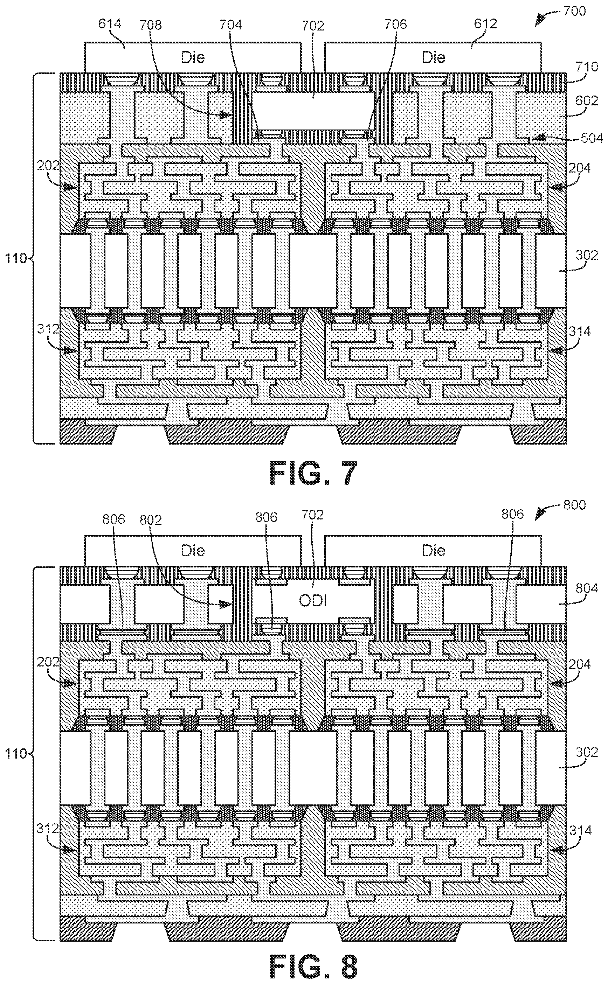

In some examples, the interconnect die 610 can include through bridge vias to provide interconnects between the die 612 and the second redistribution block 204 and/or the second die 614 and the first redistribution block 202. Such an interconnect die 610 may be referred to as an omni-directional interposer that can provide electrical connections between one or more of (i) the adjacent first and second redistribution blocks 202, 204, (ii) the adjacent dies 612, 614, and/or (iii) the dies 612, 614 and the first and second redistribution blocks 202, 204. In some examples, to enable electrical connections between the first and second redistribution blocks 202, 204 to pass through an omni-directional interposer instead of the interconnect bridge shown in FIG. 6, the additional redistribution layers 504 may need to be modified to eliminate a direct connection as shown in FIG. 6. FIG. 7 illustrates another example IC package 700 that is modified in this manner relative to the IC package 600 of FIG. 6. That is, the example IC package 700 of FIG. 7 is substantially the same as the example IC package 600 shown in FIG. 6 except as noted herein. As such, the same reference numbers will be used in FIG. 7 to identify the same or similar features shown in FIGS. 2-6. Further, the description of such features provided above in connection with FIGS. 2-6 applies similarly to the corresponding features shown in FIG. 7.

As shown in FIG. 7, the example IC package 700 includes an omni-directional interposer 702 that is electrically connected to both the first and second redistribution blocks 202, 204 through different (isolated) portions of the additional redistribution layer 504. More particularly, in this example, the omni-directional interposer 702 is connected to separate contacts 704, 706 in the additional redistribution layer 504 via solder bumps. In some examples, a cavity 708 (e.g., an opening) is provided in the additional layer of dielectric material 602 to enable attachment of the omni-directional interposer 702 to the contacts 704, 706. In some examples, the cavity 708 is filled with a filler material 710 (e.g., a mold compound, an epoxy, a liquid dielectric, an underfill, or other encapsulant) to enclose and/or encapsulate the omni-directional interposer 702. In this example, the filler material 710 also serves as an underfill material to surround the contacts of the first and second dies 612, 614 mounted to the package substrate 110. In other examples, a different material can be employed as an underfill. In other examples, the underfill can be omitted.

In some examples, an alternative component can be used in place of the omni-directional interposer 702 in the illustrated example of FIG. 7. For instance, in some examples, a silicon bridge can be used. In other examples, an organic bridge can be used. In other examples, an EMIB-T (e.g., an EMIB with through silicon vias (TSVs)) can be used.

FIG. 8 illustrates an example IC package 800 corresponding to another example implementation of the example IC package 100 of FIG. 1. The example IC package 800 of FIG. 8 is substantially the same as the example IC package 700 shown in FIG. 7 except as noted herein. As such, the same reference numbers will be used in FIG. 8 to identify the same or similar features shown in FIG. 7. Further, the description of such features provided above in connection with FIG. 7 (and the corresponding features in FIGS. 2-6) applies similarly to the corresponding features shown in FIG. 8. Instead of providing the cavity 708 in the additional layer of dielectric material 602 as shown in FIG. 7, in the illustrated example of FIG. 8, the omni-directional interposer 702 is embedded within a cavity 802 (e.g., opening) within a second glass core 804. In this example, both the glass core 804 and the omni-directional interposer 702 are attached, as a unit, to the underlying additional redistribution layer 504 via solder connections 806 at the location of contact pads on the omni-directional interposer 702 as well as at the location of TGVs extending through the second glass core 804.

In the example IC packages 600, 700, 800 of FIGS. 6-8, the redistribution blocks 202, 204, 312, 314 are attached to the glass core 302 with the solder bumps 310 (FIG. 3) through a thermal compression bonding process. However, other methods of attachment are possible. For instance, FIGS. 9-11 illustrate different stages in a fabrication process to connect redistribution blocks 902, 904, 906, 908 to a glass core 910 through hybrid bonding. In some examples, the redistribution blocks 902, 904, 906, 908 of FIGS. 9-11 can be used instead of any of the example redistribution blocks 140, 142, 144, 146, 202, 204, 312, 314 in FIGS. 1-8. Further, the example glass core 910 of FIGS. 9-11 can be used instead of any of the example glass cores 130, 302 of FIGS. 1-8. The example redistribution blocks 902, 904, 906, 908 of FIGS. 9-11 are substantially similar to the redistribution blocks 202, 204, 312, 314 in FIGS. 2-8 except that the redistribution blocks 902, 904, 906, 908 include a glass base 912 (e.g., a glass core) in addition to the dielectric material 208 within which metal interconnects 212, 214, 316, 318 are provided. Specifically, in this example, the glass base 912 is on the side of each redistribution block 902, 904, 906, 908 that is facing towards the glass core 910. Further, in this example, the glass base 912 of each redistribution block 902, 904, 906, 908 includes TGVs 914 extending therethrough that are to align with corresponding TGVs 916 extending through the glass core 910.

Unlike the TGVs 304 in FIGS. 3-8, the TGVs 916 in the glass core 910 of FIG. 9 do not include terminating contact pads on the outer surfaces 918, 920 of the glass core 910. Instead, in this example, the ends of the TGVs 916 are flush with the outer surfaces 918, 920 of the glass core 910. In some examples, the flush nature of the TGVs 916 relative to the outer surfaces 918, 920 of the glass core 910 is achieved through a chemical mechanical planarization (CMP) process. Similarly, as shown in FIG. 9, the TGVs 914 in the glass base 912 of each redistribution block 902, 904, 906, 908 is flush with an outer surface 922 of the glass base 912. In some examples, this is also achieved through a planarization (e.g., CMP) process.

In the illustrated example of FIG. 9, the interfacing surfaces (e.g., the outer surfaces 918, 920, 922) of the glass core 910 and the glass base 912 of each redistribution block 902, 904, 906, 908 are planarized to enable hybrid bonding at the surfaces. That is, as shown in the illustrated example of FIG. 10, the redistribution blocks 902, 904, 906, 908 are brought into contact with and pressed against the outer surfaces 918, 920 of the glass core 910. In this example, the metal (e.g., copper) in the TGVs 914 in the redistribution blocks 902, 904, 906, 908 are fusion bonded to the metal (e.g., copper) in the TGVs 916 in the glass core 910. Similarly, in this example, the glass material in each glass base 912 is fusion bonded to the glass material in the glass core 910.

In some examples, the fusion bonds between the disaggregated components (e.g., the individual redistribution blocks 902, 904, 906, 908 and the separate glass core 910) can produce a seamless or nearly seamless connection between the interfacing surfaces. For this reason, there is no line shown at the interface between the surfaces in FIG. 10. However, the presence of the hybrid bonds may still be apparent due to the stepped profile at the interface between the TGVs 914 in each glass base 912 and the TGVs 916 in the glass core 910. In this example, the stepped profile is pronounced because the TGVs 914 in each glass base 912 have a smaller size (e.g., a smaller diameter) than the TGVs 916 in the glass core 910. In other examples, the different TGVs 914, 916 can be the same size. In such examples, there may still be a stepped profile due to slight misalignments between corresponding ones of the TGVs 914, 916. In some examples, the TGVs 914 in each glass base 912 have a larger size (e.g., a larger diameter) than the TGVs 916 in the glass core 910.

In some examples, the hybrid bonding between the redistribution blocks 902, 904, 906, 908 and the glass core 910 results in each glass base 912 effectively becoming part of the final overall core for the package substrate (e.g., the glass core 130 of FIG. 1). Thus, in some examples, the glass bases 912 effectively increases the thickness of the core for increased rigidity relative to the example IC packages 600, 700, 800 of FIGS. 6-8. Alternatively, in some examples, the glass core 910 in FIG. 9 can be fabricated to be thinner than the glass core 302 in FIGS. 6-8 so that the overall thickness of the final core (including the thickness of the glass bases 912 in combination with the glass core 910) is comparable to, or even less than, the thickness of the glass core 302 in the examples of FIGS. 6-8.

Once the redistribution blocks 902, 904, 906, 908 are reconstituted on the glass core 910, as shown in FIG. 10, the fabrication process can proceed in a similar manner to what was described above in connection with FIGS. 5 and 6. Thus, as shown in the illustrated example of FIG. 11, a filler material 1102 (e.g., a mold compound, an epoxy, a liquid dielectric, an underfill, or other encapsulant) is deposited to fill the gaps between the redistribution blocks 902, 904, 906, 908. In this example, the filler material 1102 extends up to but not overtop of the outer surfaces of the redistribution blocks 902, 904, 906, 908. In other examples, filler material 1102 can extend beyond the redistribution blocks 902, 904, 906, 908 to serve as a dielectric material that separates metal in additional redistribution layers similar to the redistribution layers 504, 506 in FIGS. 5-8.

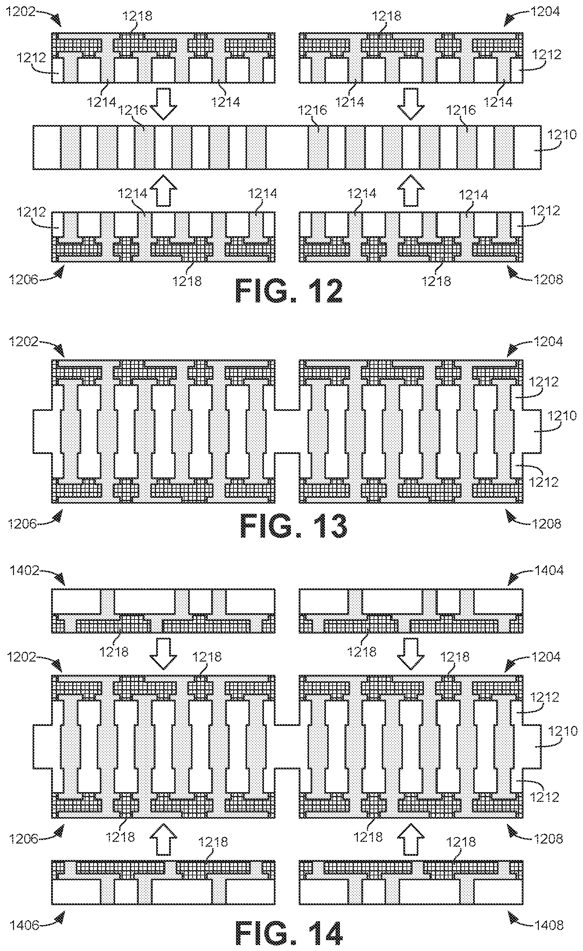

FIGS. 12-16 illustrate different stages of fabrication in an example process to fabricate another implementation of the example IC package 100 of FIG. 1. Specifically, the process represented in FIGS. 12-16 enables multiple different (disaggregated) redistribution blocks to be stacked on top of one another using hybrid bonding. The stage of fabrication represented in FIG. 12 is similar to FIG. 9 with first, second, third, and fourth redistribution blocks 1202, 1204, 1206, 1208 being transferred (e.g., via a pick-and-place process) to a glass core 1210. As in FIG. 9, each of the redistribution blocks 1202, 1204, 1206, 1208 in FIG. 12 include a glass base 1212 with TGVs 1214 extending therethrough that form fusion bonds with TGVs 1216 in the glass core 1210. Likewise, the glass base 1212 associated with each redistribution block 1202, 1204, 1206, 1208 forms fusion bonds with the glass in the glass core 1210. FIG. 13 illustrates the assembly after the hybrid bonding of the redistribution blocks 1202, 1204, 1206, 1208 with the glass core 1210 similar to what is shown in FIG. 10.

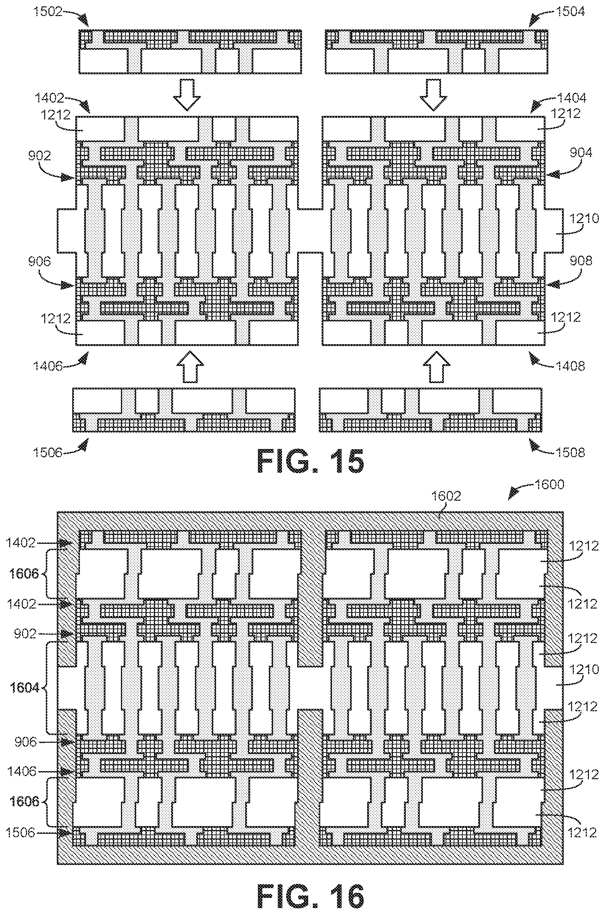

FIGS. 12 and 13 differ from FIGS. 9 and 10 in that the redistribution blocks 1202, 1204, 1206, 1208 include a different dielectric material between the metal layers that define the interconnects through the redistribution blocks 1202, 1204, 1206, 1208. In the illustrated example of FIGS. 9 and 10, the dielectric material 208 in the redistribution blocks 902, 904, 906, 908 is represented as including an organic epoxy laminate (as commonly used in build-up regions of known package substrates). By contrast, the redistribution blocks 1202, 1204, 1206, 1208 in FIGS. 12 and 13 include an organic dielectric material 1218 composed of polyimide. Polyimide is used for the organic dielectric material 1218 in the redistribution blocks 1202, 1204, 1206, 1208 to facilitate additional (fifth, sixth, seventh, and eighth) redistribution blocks 1402, 1404, 1406, 1408 to be hybrid bonded to respective ones of the first set of the redistribution blocks 1202, 1204, 1206, 1208 as represented in FIG. 14. More particularly, as shown in FIG. 14, the second set of redistribution blocks 1402, 1404, 1406, 1408 are oriented with the glass base 1212 facing away from the central glass core 1210. That is, as shown in FIG. 14, the second set of redistribution blocks 1402, 1404, 1406, 1408 are transferred to the glass core 1210 in a flipped orientation relative to the first set of redistribution blocks 1202, 1204, 1206, 1208 shown in FIG. 12. In this manner, the organic dielectric material 1218 of the interfacing redistribution blocks (e.g., the first and fifth blocks 1202, 1402, the second and sixth blocks 1204, 1404, the third and seventh blocks 1206, 1406, and the fourth and eighth blocks 1208, 1408) come into direct contact to form fusion bonds, as represented in FIG. 15. Further, exposed portions of the metal at the interfacing surfaces of the redistribution blocks 1202, 1204, 1206, 1208, 1402, 1404, 1406, 1408 also come into contact to form fusion bonds that complete the hybrid bond at those interfacing surfaces.

After this second layer of hybrid bonding, the outer surface of the combined assembly is glass. Specifically, as shown in FIG. 15, the glass base 1212 in each of the fifth, sixth, seventh, and eighth redistribution blocks 1402, 1404, 1406, 1408 is facing outward from the central glass core 1210. Accordingly, in some examples, another set of redistribution blocks 1502, 1504, 1506, 1508 can be added on to the previously added redistribution blocks 1402, 1404, 1406, 1408 via hybrid bonding along the interfacing glass surfaces similar to what was done in FIG. 12. This can be implemented any suitable number of times to stack any suitable number of disaggregated redistribution blocks on top of one another.

FIG. 16 illustrates the completed package substrate 1600 after the third set of redistribution blocks 1502, 1504, 1506, 1508 have been hybrid bonded to the rest of the assembly. Further, in this example, the package substrate 1600 includes a filler material 1602 (e.g., a mold compound, an epoxy, a liquid dielectric, an underfill, or other encapsulant) to encapsulate the different stacks of redistribution blocks, thereby completing the reconstitution of the disaggregated components into a consolidated substrate. In some examples, the package substrate 1600 shown in FIG. 16 may undergo subsequent processing to add additional redistribution layers using conventional methods to fabricate build-up regions as discussed above in connection with any of FIGS. 5-8.

As shown in FIG. 16, the example package substrate 1600 includes multiple glass cores that are spaced apart from one another. More particularly, the package substrate 1600 includes primary or main glass core 1604 that includes the initial glass core 1210 and fusion bonded glass bases 1212 from the first, second, third, and fourth redistribution blocks 902, 904, 906, 908. Further, the package substrate 1600 includes secondary glass cores 1606 corresponding to the fusion bonded glass bases 1212 from the corresponding stacked pairs of the other redistribution blocks 1402, 1404, 1406, 1408, 1502, 1504, 1506, 1508.

As shown in the illustrated example of FIGS. 12-16, the hybrid bonds at each successive interface between adjacent layers of redistribution blocks in the stack alternate between (1) glass and metal and (2) polyimide and metal. In other examples, disaggregated redistribution blocks can be stacked on top of one another using other attachment techniques. For instance, in some examples, a second redistribution block may be stacked on top of and electrically coupled to a first redistribution block using solder (e.g., via thermal compression bonding through the use of solder bumps similar to the bumps 310 of FIG. 3). In other examples, different redistribution blocks may be stacked on one another and electrically coupled via an anisotropic conductive film disposed at the interface between two redistribution blocks. In some examples, different attachment techniques may be used at different layers in a stack of redistribution blocks. For instance, in some examples, a first redistribution block is hybrid bonded directly to a glass core and then a second redistribution block is solder bonded to the first redistribution block. In other examples, solder bonding is used between the first redistribution block and the glass core and hybrid bonding is used between the second redistribution block and the first redistribution block. Any other suitable combination of attachment techniques may additionally or alternatively be used within a single stack of redistribution blocks and/or across different stacks of redistribution blocks. Further, different attachment techniques may be used for laterally adjacent redistribution blocks on a glass core, regardless of whether the redistribution blocks are part of a stack of multiple redistribution blocks.

In the illustrated example of FIGS. 12-16, the redistribution blocks 1202, 1204, 1206, 1208, 1402, 1404, 1406, 1408, 1502, 1504, 1506, 1508 are thinner (e.g., have fewer metal layers) than the redistribution blocks 202, 204, 312, 314, 902, 904, 906, 908 shown in FIGS. 2-11. However, in other examples, the redistribution blocks 1202, 1204, 1206, 1208, 1402, 1404, 1406, 1408, 1502, 1504, 1506, 1508 of FIGS. 12-15 can be as thick as (e.g., contain as many metal later) or thicker (e.g., contain more metal layers) than the blocks 202, 204, 312, 314, 902, 904, 906, 908 shown in FIGS. 2-11.

Although the organic dielectric material 1218 used for the redistribution blocks 1202, 1204, 1206, 1208, 1402, 1404, 1406, 1408, 1502, 1504, 1506, 1508 in FIGS. 12-16 is shown and described as including polyimide, other materials are possible. For instance, in some examples, some or all of the redistribution blocks 1202, 1204, 1206, 1208, 1402, 1404, 1406, 1408, 1502, 1504, 1506, 1508 in FIGS. 12-15 include an organic epoxy laminate as described above for the examples in FIGS. 2-11. Further, in some examples, one or more of the redistribution blocks 140, 142, 144, 146, 202, 204, 312, 314, 902, 904, 906, 908 in FIGS. 1-11 may include polyimide instead of an organic epoxy laminate as the dielectric material supporting the metal interconnects contained therein.

FIGS. 17-24 illustrate different stages of fabrication in an example process to fabricate another implementation of the example IC package 100 of FIG. 1. Unlike what is shown and described above in connection with FIG. 2, the example process represented in FIGS. 17-24 does not involve a sacrificial carrier (e.g., the carrier 206 of FIG. 2) on which redistribution blocks are fabricated. Rather, as represented in FIG. 17, the process begins with a glass cloth ply (GCP) reinforced peelable core 1700. That is, the peelable core 1700 includes a central layer 1702 made of metal (e.g., copper) that includes a glass reinforced organic dielectric 1704 (e.g., an epoxy-based prepreg layer with glass cloth) on both sides. The peelable core 1700 provides sufficient rigidity in itself to serve as the basis for subsequent processing operations without the need for a separate sacrificial carrier.

FIG. 18 represents the stage in the process after adding at least some build-up layers 1802, 1804 on either side of the peelable core 1700. In this example, the build-up layers 1802, 1804 include one or more layers of dielectric material 1806 (e.g., an organic epoxy laminate), and one or more layers of metal 1808 (e.g., copper). Further, as shown in the illustrated example, metal vias 1810 are added that extend through the glass reinforced organic dielectric 1704. In some examples, metal vias are also added to extend through the one or more layers of dielectric material 1806. However, such vias are not shown in FIG. 18 for purposes of simplicity and clarity.

FIG. 19 represents the de-paneling or peeling apart of the materials on either side of the central layer 1702 of the peelable core 1700. The separate portions serve as the basis for two (e.g., first and second) redistribution blocks 1902, 1904 that may be subsequently processed independent of one another. Thus, at the stage in the process represented in FIG. 19, the redistribution blocks 1902, 1904 become disaggregated from one another.

FIGS. 20A and 20B represent the respective first and second redistribution blocks 1902, 1904 following subsequent processing specific to each redistribution block 1902, 1904. More particularly, in the illustrated example of FIG. 20A and 20B, the subsequent processing includes the addition of more layers of dielectric material 1806 to cover the outermost (exposed) portions of the layers of metal 1808 and/or the metal vias 1810. In other examples, any other suitable processes may be performed to further process and/or develop the first and second redistribution blocks 1902, 1904.

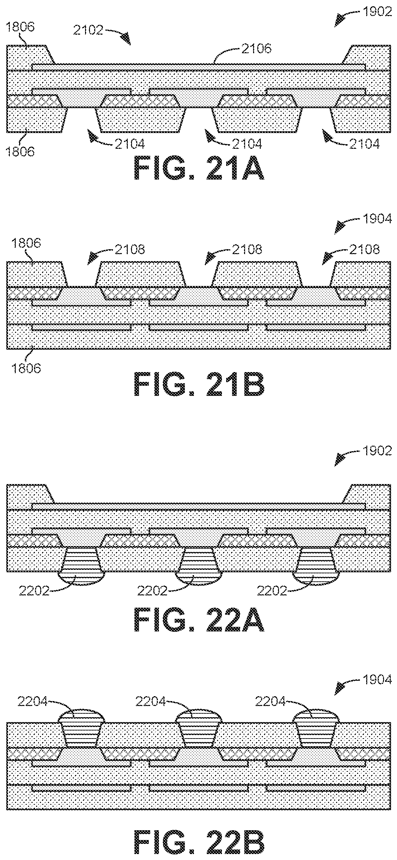

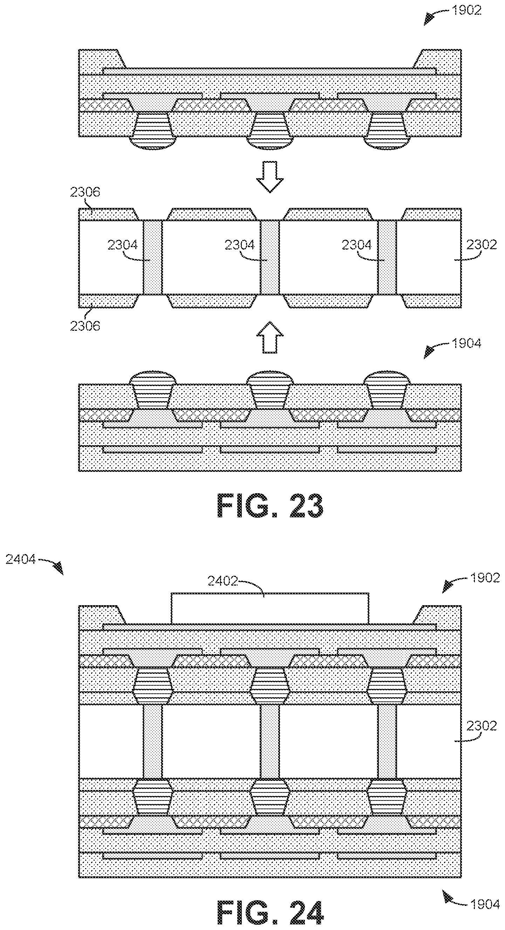

FIGS. 21A and 21B represent the respective first and second redistribution blocks 1902, 1904 following the creation of openings in the additional layers of the dielectric material 1806 added in FIGS. 20A and 20B. More particularly, in the illustrated example of FIG. 21A, a first opening 2102 (e.g., a cavity) is provided on a first (top) side of the first redistribution block 1902 and second openings 2104 are provided on the second (bottom) side of the first redistribution block 1902. In this example, the first opening 2102 uncovers a metal plane 2106 that is relatively large to serve as a mounting surface for an interconnect die 2402 (e.g., an interconnect bridge) as shown in FIG. 24. Further, the second openings 2104 expose portions of the underlying metal that correspond to locations for first solder bumps 2202 shown in FIG. 22A. In the illustrated example of FIG. 21B, third openings 2108 are provided on a first (top) side of the second redistribution block 1904 to expose portions of the underlying metal that corresponds to locations for second solder bumps 2204 shown in FIG. 22B.

FIGS. 22A and 22B represent the respective first and second redistribution blocks 1902, 1904 following the addition of solder into the second and third openings 2104, 2108 to define the first and second solder bumps 2202, 2204, respectively. With the solder bumps 2202, 2204 added to the redistribution blocks 1902, 1904, the redistribution blocks 1902, 1904 are ready to be added to a disaggregated glass core. FIG. 23 represents the redistribution blocks 1902, 1904 being transferred (e.g., via a pick-and-place process) to a glass core 2302. In this example, the glass core 2302 has already gone through various fabrication processing operations to include TGVs 2304. Further, in this example, the glass core 2302 has been covered by a layer of dielectric material 2306 that has been provided with openings that expose the TGVs 2304.

FIG. 24 represents the stage of fabrication after the redistribution blocks 1902, 1904 have been solder bonded to the glass core 2302 (e.g., via thermal compression bonding). Further, in this example, the interconnect die 2402 has been added to the metal plane 2106 to complete the basic structure of an example package substrate 2404. In some examples, additional fabrication processes may be implemented to further build up the package substrate 2404. For instance, in some examples, the assembly can be enclosed in a filler material and/or additional redistribution layers can be added similar to the other examples discussed above. Further, although only a single redistribution block 1902, 1904 is shown on either side of the glass core in FIG. 24, in other examples, more than one redistribution block can be positioned on the same side (e.g., adjacent to one another and/or stacked on top of one another) as discussed in the other examples above.

As discussed above, disaggregating redistribution blocks from one another reduces the size of individual units that can then be subsequently combined to define different portions of a build-up region and/or different portions of a full package substrate. Such disaggregation reduces the likelihood of defects occurring in any given unit (e.g., any given redistribution block). As a result, example techniques disclosed herein can lower yield loss relative to known approaches in which an entire build-up region and/or an entire package substrate is fabricated as a single unit directly on a substrate core. Furthermore, disaggregating the redistribution blocks from the substrate core (e.g., a glass core) enables different processes to be used in fabricating the different components that may otherwise be unavailable if a complete package substrate is fabricated from the glass core and up. More particularly, while glass cores provide certain mechanical and electrical advantages over organic epoxy-based cores, glass cores are relatively fragile and not conducive to certain fabrication processes that are of little concern for organic epoxy-based cores. However, by separating the fabrication of the build-up regions of a package substrate from the core to produce disaggregated portions of the build-up region (e.g., discrete redistribution blocks), such fabrication processes specific to organic substrates can be used in developing the redistribution blocks before they are attached to the glass core. As such, there is no concern for such processes causing problems for the glass core.

FIGS. 25-28 illustrate an alternative example package substrate constructed in accordance with teachings disclosed herein to protect a glass core included therein. Specifically, FIG. 25 illustrates an array of discrete glass cores 2502 being transferred into a frame 2504 to reconstitute the glass cores 2502 into a panel. The glass cores 2502 can be constructed similarly to the glass core 130 discussed above in connection with FIG. 1. In some examples, the frame 2504 is an organic and/or epoxy-based structure (e.g., an epoxy-based prepreg layer with glass cloth) that provides rigidity to the reconstituted panel. As shown in the illustrated example, the frame 2504 includes windows 2506 (e.g., openings) that extend through the frame 2504. The windows 2506 are larger than the glass cores 2502 so that the glass cores 2502 can be disposed therein.

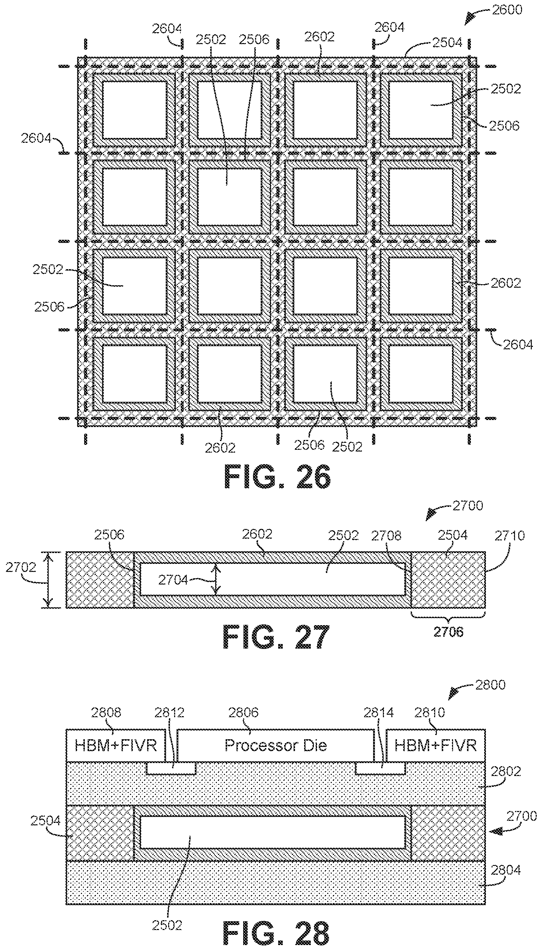

FIG. 26 illustrates a reconstituted glass panel 2600 with the individual glass cores 2502 positioned within the windows 2506 of the frame 2504 of FIG. 25. As shown in the illustrated example, the glass cores 2502 are smaller than the windows 2506 such that there is a gap between the glass cores 2502 and the windows 2506. In some examples, the glass cores 2502 are held in place within the windows 2506 by filling the gaps with a mold compound 2602 (e.g., an epoxy or other encapsulant). FIG. 27 is a cross-sectional view of one of the glass cores 2502 within a corresponding window 2506 of the frame 2504. As shown in the illustrated example, the glass cores 2502 are completely encased or encapsulated in the mold compound. That is, in some examples, the mold compound 2602 not only surrounds the perimeter or outer edges of the glass cores 2502, but also cover the top and bottom surfaces of the glass cores 2502. In some examples, as shown in FIG. 27, this is accomplished by fabricating the frame 2504 with a first thickness 2702 that is greater than a second thickness 2704 of the glass cores 2502. In other examples, the second thickness 2704 can be the same as or greater than the first thickness 2702. In some such examples, the mold compound 2602 may still extend across the top and bottom surfaces of the glass cores 2502. In some such examples, the mold compound 2602 also extends across the top and/or bottom surface of the frame 2504. As a result of the encapsulation of the glass cores 2502 by the mold compound 2602 within the structural frame 2504, the glass core 2502 can be more readily handled and taken through subsequent fabrication processes typically limited to organic-based substrates.

Structural support frames, such as the frame 2504 of FIGS. 25 and 26, have been used in the past to reconstitute panels. However, in the past, the frame has been used as a temporary support that is removed when the panel is cut (e.g., singulated) into individual units. Unlike these past approaches, examples disclosed herein retain at least some portion(s) of the frame 2504 after singulation. For instance, FIG. 26 shows example saw streets 2604 (represented by dashed lines) that pass through the frame 2504 at locations spaced apart from the windows 2506 such that the material of the frame 2504 immediately surrounding and defining the windows 2506 is retained. FIG. 27 is a cross-sectional view of one of the glass cores 2502 showing retained portion(s) of the frame 2504 along the lateral edges of the glass core 2502. In some examples, the entire assembly shown in FIG. 27 serves as a hybrid core 2700 for a package substrate, with the hybrid core 2700 including both organic (e.g., epoxy) and inorganic (e.g., glass) materials.

As shown in FIG. 27, the retained portions(s) of the frame 2504 include a wall 2706 that surrounds some or all of the lateral edges of the glass core 2502. In the illustrated example, the wall 2706 has an inner surface 2708 and an outer surface 2710. In this example, the inner surface 2708 defines the perimeter of the window 2506 and the outer surface 2710 defines an outer perimeter of the hybrid core 2700 that corresponds to the outer perimeter of a corresponding package substrate as shown in FIG. 28.

FIG. 28 illustrates a complete IC package 2800 that has been fabricated using the hybrid core 2700 of FIG. 27. That is, as shown in the illustrated example, the complete IC package 2800 of FIG. 28 includes the glass core 2502 with the retained portion(s) of the frame 2504. In this example, the IC package 2800 includes build-up regions 2802, 2804 on either side of the core 2700. In some examples, the build-up regions 2802 are fabricated using standard techniques with alternating layers of dielectric material and layers of patterns metal laminated directly on to the hybrid core 2700. Additionally or alternatively, in some examples, the build-up regions 2802, 2804 include one or more disaggregated redistribution blocks as discussed above in connection with FIGS. 1-24.

In the illustrated example of FIG. 28, the IC package 2800 includes a processor die 2806 and two memory dies 2808, 2810. In this example, the memory dies 2808, 2810 are high bandwidth memory dies that include fully integrated voltage regulators. Further, in this example, the processor die 2806 is communicatively coupled to the memory dies 2808, 2810 via silicon-based interconnect dies 2812, 2814 embedded within the first build-up region 2802. In other examples, one or more of the dies 2806, 2808, 2810, 2812, 2814 may be omitted and/or arranged in any suitable manner.

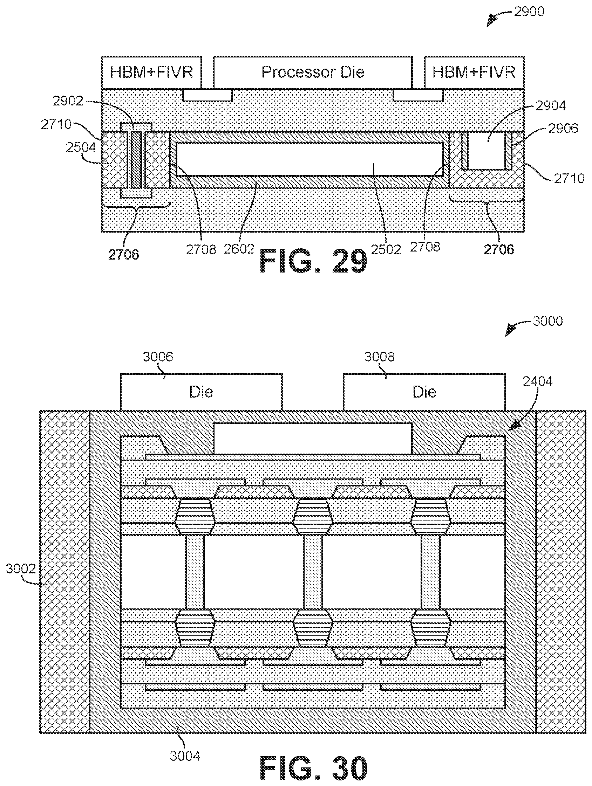

FIG. 29 illustrates another example IC package 2900 that is similar to the IC package 2800 of FIG. 28. However, the IC package 2900 of FIG. 29 includes electric components (e.g., functional components) within the retained portion(s) of the frame 2504. That is, the electric components are embedded and/or otherwise provided in the wall 2706 of the frame 2504 between the inner and outer surfaces 2708, 2710 of the wall 2706. The electric components can be any suitable component. For instance, in some examples, the frame 2504 contains one or more coaxial metal inductor loop 2902 (e.g., a coax MIL) and/or other type of inductor (e.g., a magnetic inductor array (MIA)). Positioning a coaxial metal inductor loop 2902 within the frame 2504 at the location shown in FIG. 29 can be advantageous to provide the coaxial metal inductor loop 2902 close to the fully integrated voltage regulator within the memory die directly above the coaxial metal inductor loop 2902. Additionally or alternatively, in some examples, the frame 2504 contains one or more deep trench capacitor 2904, some other type of capacitor, and/or other semiconductor-based (silicon-based) component. In this example, the deep trench capacitor 2904 is disposed within a cavity 2906 on one side of the frame 2504. However, such components can be embedded within the frame in other manners. For instance, in some examples, the cavity 2906 is an opening that extends the full way through the frame and the deep trench capacitor 2904 (or other component) is attached to the sidewall of the opening or suspended within the opening by the mold compound 2602 in a similar manner to the glass core 2502 within the window 2506 discussed above in connection with FIGS. 26 and 27.

In some examples, the electric components (e.g., the coaxial metal inductor loop 2902 and/or the deep trench capacitor 2904) embedded in the retained portion(s) of the frame 2504 are added to the frame 2504 prior to insertion of the glass cores 2502 into the frame. Additionally or alternatively, in some examples, the electric components are added into the frame 2504 after the glass core 2502 has been added and encased in the mold compound 2602.

In some examples, one or more redistribution blocks (including any of the redistribution blocks 140, 142, 144, 146, 202, 204, 312, 314, 902, 904, 906, 908, 1202, 1204, 1206, 1208, 1402, 1404, 1406, 1408, 1502, 1504, 1506, 1508, 1902, 1904 disclosed herein) can be embedded within the retained portions of the frame 2504 along with the glass core. For instance, FIG. 30 illustrates another example IC package 3000 constructed in accordance with teachings disclosed herein. In this example, the IC package 3000 includes the example package substrate 2404 of FIG. 24 disposed within a frame 3002. In this example, the frame 3002 is similar to the frame 2504 of FIGS. 25-29 except that the frame 3002 of FIG. 3000 is thicker to provide sufficient depth for the package substrate 2404 to be disposed therein. As shown in FIG. 30, the package substrate 2404 is encased in a mold compound 3004 similar to the mold compound 2602 of FIGS. 26-29.

In the illustrated example of FIG. 30, first and second dies 3006, 3008 are attached directly to the underlying assembly that is externally supported by the frame 3002. However, in other examples, there may be a build-up region with one or more redistribution layers similar to what is described above regarding the first build-up region 2802 in FIG. 28 between the dies 3006, 3008 and the underlying assembly. In some examples, one or more electric components (e.g., a coax MIL, a deep trench capacitor, etc.) as described above in connection with FIG. 29 can be included in the frame 3002 of FIG. 30. Further, although the example IC package 3000 of FIG. 30 is shown as including the package substrate 2404 of FIG. 24, in other examples, any of the other package substrates and/or redistribution blocks constructed and arranged in any suitable manner in accordance with this disclosure may additionally or alternatively be included within the frame 3002.

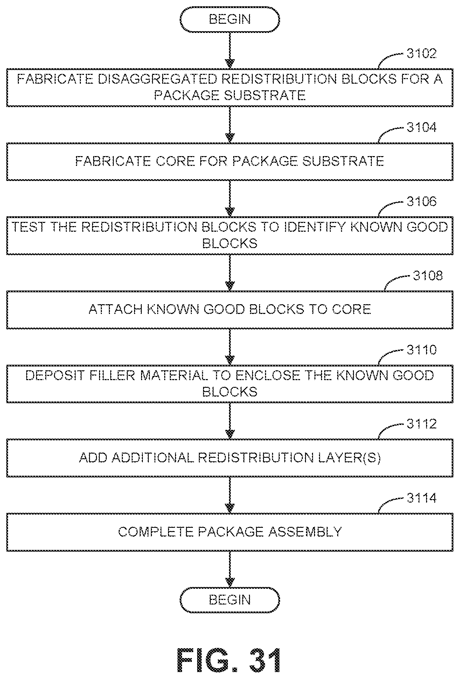

FIG. 31 is a flowchart representative of an example method that may be performed to fabricate any one of the example IC packages 100, 600, 700, 800, 2404 of FIGS. 1-24. In some examples, some or all of the operations outlined in the example method of FIG. 31 are performed automatically by equipment that is programmed to perform the operations. Although the example method is described with reference to the flowchart illustrated in FIG. 31, many other methods may alternatively be used. For example, the order of execution of the blocks may be changed, and/or some of the blocks described may be combined, divided, re-arranged, omitted, eliminated, and/or implemented in any other way. Further, in some examples, additional processing operations can be performed before, between, and/or after any of the blocks represented in the illustrated example.

The example process of FIG. 31 begins at block 3102 by fabricating disaggregated redistribution blocks for a package substrate. The redistribution blocks can correspond to the any of the example redistribution blocks 140, 142, 144, 146, 202, 204, 312, 314, 902, 904, 906, 908, 1202, 1204, 1206, 1208, 1402, 1404, 1406, 1408, 1502, 1504, 1506, 1508, 1902, 1904 disclosed herein. At block 3104, the example method involves fabrication of a core for the package substrate. The core can correspond to any of the example cores 130, 302, 910, 1210, 2302 disclosed herein. At block 3106, the example method involves testing the redistribution blocks to identify known good blocks. At block 3108, the example method involves attaching the known good blocks to the core. In some examples, the known good blocks can be attached directly to the core. In other examples, the known good blocks can be attached indirectly by stacking the known good blocks and previously attached known good blocks.

At block 3110, the example method involves depositing a filler material to enclose the known good blocks. In some examples, such as when only one redistribution block is attached that is the same size as the underlying core, block 3110 may be omitted. At block 3112, the example method involves adding additional redistribution layer(s). In some examples, block 3112 is omitted. At block 3114, the example method involves completing the package assembly. For example, dies may be attached to the package substrate produced by combining the redistribution blocks to the core. Thereafter, the example process of FIG. 31 ends.

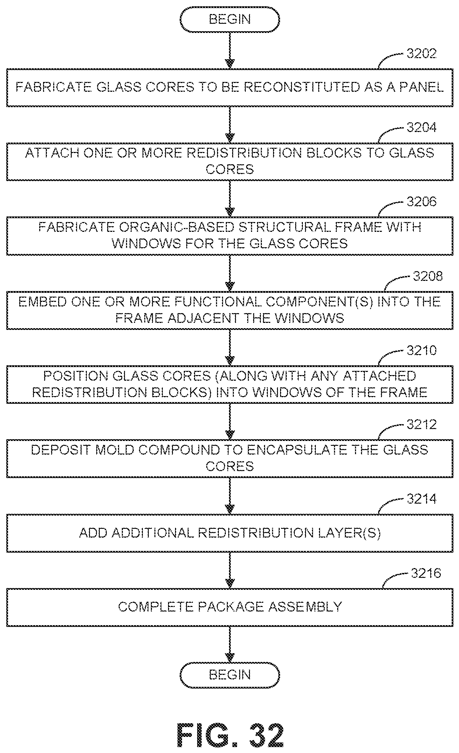

FIG. 32 is a flowchart representative of an example method that may be performed to fabricate any one of the example IC packages 2800, 2900, 3000 of FIGS. 25-30. In some examples, some or all of the operations outlined in the example method of FIG. 32 are performed automatically by equipment that is programmed to perform the operations. Although the example method is described with reference to the flowchart illustrated in FIG. 32, many other methods may alternatively be used. For example, the order of execution of the blocks may be changed, and/or some of the blocks described may be combined, divided, re-arranged, omitted, eliminated, and/or implemented in any other way. Further, in some examples, additional processing operations can be performed before, between, and/or after any of the blocks represented in the illustrated example.

The example process of FIG. 32 begins at block 3202 by fabricating glass cores to be reconstituted as a panel. In some examples, the glass cores correspond to the glass cores 2502 of FIG. 25. In other examples, the glass cores correspond to any of the other example cores 130, 302, 910, 1210, 2302 disclosed herein. At block 3204, the example method involves attaching one or more redistribution blocks to the glass cores. The redistribution blocks can correspond to the any of the example redistribution blocks 140, 142, 144, 146, 202, 204, 312, 314, 902, 904, 906, 908, 1202, 1204, 1206, 1208, 1402, 1404, 1406, 1408, 1502, 1504, 1506, 1508, 1902, 1904 disclosed herein. In some examples, implementation of block 3204 is based on the implementation of blocks 3102, 3106, 3108 of FIG. 31. In some examples, block 3204 of FIG. 32 is omitted.

At block 3206, the example method involves fabricating an organic-based structural frame with windows for the glass cores. In some examples, the frame corresponds to the example frames 2504, 3002 disclosed herein. At block 3208, the example method involves embedding one or more electric component(s) (e.g., a coax MIL, a deep trench capacitor, etc.) into the frame adjacent to the windows. In some examples, block 3208 is omitted. At block 3210, the example method involves positioning the glass cores (along with any attached redistribution blocks) into the windows of the frame.

At block 3212, the example method involves depositing a mold compound to encapsulate the glass cores (and any associated redistribution blocks). At block 3214, the example method involves adding additional redistribution layer(s). In some examples, the additional redistribution layer(s) include one or more redistribution blocks, as disclosed herein. In some examples, block 3214 is omitted. At block 3216, the example method involves completing the package assembly. Thereafter, the example process of FIG. 32 ends.

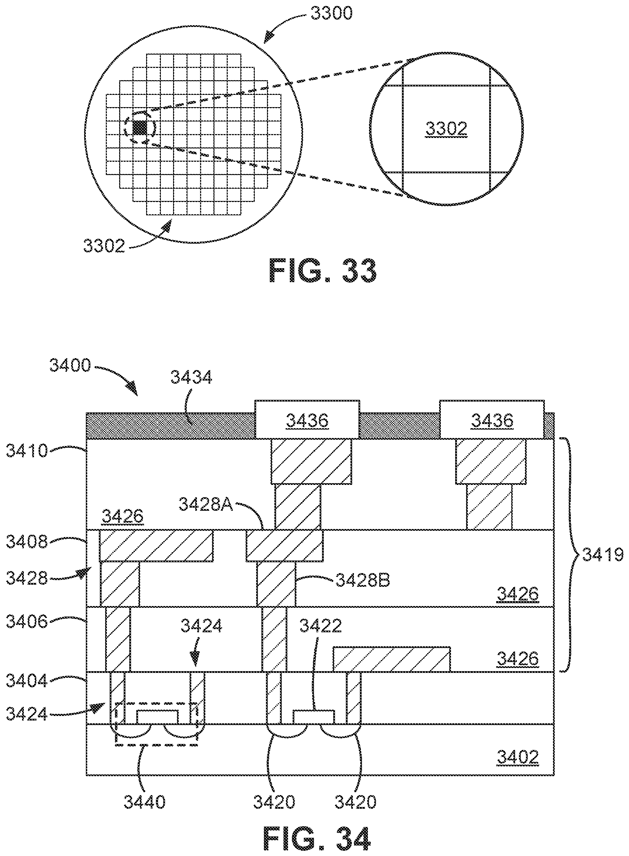

The example IC packages 100, 600, 700, 800, 2404, 2800, 2900, 3000 disclosed herein may be included in any suitable electronic component. FIGS. 33-36 illustrate various examples of apparatus that may include or be included in the IC packages 100, 600, 700, 800, 2404, 2800, 2900 disclosed herein.

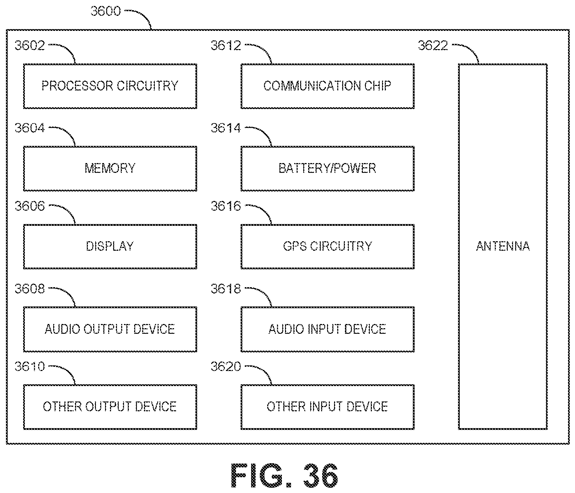

FIG. 33 is a top view of a wafer 3300 and dies 3302 that may be included in the IC packages 100, 600, 700, 800, 2404, 2800, 2900, 3000 of FIG. 1-30 (e.g., as any suitable ones of the dies 106, 108, 126, 610, 612, 614, 702, 2402, 2806, 2808, 2810, 2812, 2814, 3006, 3008). The wafer 3300 includes semiconductor material and one or more dies 3302 having circuitry. Each of the dies 3302 may be a repeating unit of a semiconductor product. After the fabrication of the semiconductor product is complete, the wafer 3300 may undergo a singulation process in which the dies 3302 are separated from one another to provide discrete "chips." The die 3302 includes one or more transistors (e.g., some of the transistors 3440 of FIG. 34, discussed below), supporting circuitry to route electrical signals to the transistors, passive components (e.g., traces, resistors, capacitors, inductors, and/or other circuitry), and/or any other components. In some examples, the die 3302 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry or electronics. Multiple ones of these devices may be combined on a single die 3302. For example, a memory array of multiple memory circuits may be formed on a same die 3302 as programmable circuitry (e.g., the processor circuitry 3602 of FIG. 36) and/or other logic circuitry. Such memory may store information for use by the programmable circuitry. The example IC packages 100, 600, 700, 800, 2404, 2800, 2900, 3000 disclosed herein may be manufactured using a die-to-wafer assembly technique in which some dies are attached to a wafer 3300 that includes others of the dies, and the wafer 3300 is subsequently singulated.

FIG. 34 is a cross-sectional side view of an IC device 3400 that may be included in the example IC packages 100, 600, 700, 800, 2404, 2800, 2900, 3000 of FIG. 1-30 (e.g., in any one of the dies 106, 108, 126, 610, 612, 614, 702, 2402, 2806, 2808, 2810, 2812, 2814, 3006, 3008). One or more of the IC devices 3400 may be included in one or more dies 3302 (FIG. 33). The IC device 3400 may be formed on a die substrate 3402 (e.g., the wafer 3300 of FIG. 33) and may be included in a die (e.g., the die 3302 of FIG. 33). The die substrate 3402 may be a semiconductor substrate including semiconductor materials including, for example, n-type or p-type materials systems (or a combination of both). The die substrate 3402 may include, for example, a crystalline substrate formed using a bulk silicon or a silicon-on-insulator (SOI) substructure. In some examples, the die substrate 3402 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 3402. Although a few examples of materials from which the die substrate 3402 may be formed are described here, any material that may serve as a foundation for an IC device 3400 may be used. The die substrate 3402 may be part of a singulated die (e.g., the dies 3302 of FIG. 33) or a wafer (e.g., the wafer 3300 of FIG. 33).

The IC device 3400 may include one or more device layers 3404 disposed on and/or above the die substrate 3402. The device layer 3404 may include features of one or more transistors 3440 (e.g., metal oxide semiconductor field-effect transistors (MOSFETs)) formed on the die substrate 3402. The device layer 3404 may include, for example, one or more source and/or drain (S/D) regions 3420, a gate 3422 to control current flow between the S/D regions 3420, and one or more S/D contacts 3424 to route electrical signals to/from the S/D regions 3420. The transistors 3440 may include additional features not depicted for the sake of clarity, such as device isolation regions, gate contacts, and the like. The transistors 3440 are not limited to the type and configuration depicted in FIG. 34 and may include a wide variety of other types and/or configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 3440 may include a gate 3422 including a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and/or zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and/or lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 3440 is to be a p-type metal oxide semiconductor (PMOS) or an n-type metal oxide semiconductor (NMOS) transistor. In some implementations, the gate electrode may include a stack of two or more metal layers, where one or more metal layers are work function metal layers and at least one metal layer is a fill metal layer. Further metal layers may be included, such as a barrier layer. For a PMOS transistor, metals that may be used for the gate electrode include, but are not limited to, ruthenium, palladium, platinum, cobalt, nickel, conductive metal oxides (e.g., ruthenium oxide), and/or any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and/or aluminum carbide), and/or any of the metals discussed above with reference to a PMOS transistor (e.g., for work function tuning).

In some examples, when viewed as a cross-section of the transistor 3440 along the source-channel-drain direction, the gate electrode may include a U-shaped structure that includes a bottom portion substantially parallel to the surface of the die substrate 3402 and two sidewall portions that are substantially perpendicular to the top surface of the die substrate 3402. In other examples, at least one of the metal layers that form the gate electrode may be a planar layer that is substantially parallel to the top surface of the die substrate 3402 and does not include sidewall portions substantially perpendicular to the top surface of the die substrate 3402. In other examples, the gate electrode may include a combination of U-shaped structures and/or planar, non-U-shaped structures. For example, the gate electrode may include one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and/or silicon oxynitride. Processes for forming sidewall spacers are well known in the art and generally include deposition and etching process operations. In some examples, a plurality of spacer pairs may be used; for instance, two pairs, three pairs, or four pairs of sidewall spacers may be formed on opposing sides of the gate stack.

The S/D regions 3420 may be formed within the die substrate 3402 adjacent to the gate 3422 of corresponding transistor(s) 3440. The S/D regions 3420 may be formed using an implantation/diffusion process or an etching/deposition process, for example. In the former process, dopants such as boron, aluminum, antimony, phosphorous, or arsenic may be ion-implanted into the die substrate 3402 to form the S/D regions 3420. An annealing process that activates the dopants and causes them to diffuse farther into the die substrate 3402 may follow the ion-implantation process. In the latter process, the die substrate 3402 may first be etched to form recesses at the locations of the S/D regions 3420. An epitaxial deposition process may then be carried out to fill the recesses with material that is used to fabricate the S/D regions 3420. In some implementations, the S/D regions 3420 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 3420 may be formed using one or more alternate semiconductor materials such as germanium or a group III-V material or alloy. In further examples, one or more layers of metal and/or metal alloys may be used to form the S/D regions 3420.

Electrical signals, such as power and/or input/output (I/O) signals, may be routed to and/or from the devices (e.g., transistors 3440) of the device layer 3404 through one or more interconnect layers disposed on the device layer 3404 (illustrated in FIG. 34 as interconnect layers 3406-3410). For example, electrically conductive features of the device layer 3404 (e.g., the gate 3422 and the S/D contacts 3424) may be electrically coupled with the interconnect structures 3428 of the interconnect layers 3406-3410. The one or more interconnect layers 3406-3410 may form a metallization stack (also referred to as an "ILD stack") 3419 of the IC device 3400.

The interconnect structures 3428 may be arranged within the interconnect layers 3406-3410 to route electrical signals according to a wide variety of designs (in particular, the arrangement is not limited to the particular configuration of interconnect structures 3428 depicted in FIG. 34). Although a particular number of interconnect layers 3406-3410 is depicted in FIG. 34, examples of the present disclosure include IC devices having more or fewer interconnect layers than depicted.

In some examples, the interconnect structures 3428 may include lines 3428a and/or vias 3428b filled with an electrically conductive material such as a metal. The lines 3428a may be arranged to route electrical signals in a direction of a plane that is substantially parallel with a surface of the die substrate 3402 upon which the device layer 3404 is formed. For example, the lines 3428a may route electrical signals in a direction in and/or out of the page from the perspective of FIG. 34. The vias 3428b may be arranged to route electrical signals in a direction of a plane that is substantially perpendicular to the surface of the die substrate 3402 upon which the device layer 3404 is formed. In some examples, the vias 3428b may electrically couple lines 3428a of different interconnect layers 3406-3410 together.

The interconnect layers 3406-3410 may include a dielectric material 3426 disposed between the interconnect structures 3428, as shown in FIG. 34. In some examples, the dielectric material 3426 disposed between the interconnect structures 3428 in different ones of the interconnect layers 3406-3410 may have different compositions; in other examples, the composition of the dielectric material 3426 between different interconnect layers 3406-3410 may be the same.

A first interconnect layer 3406 (referred to as Metal 1 or "M1") may be formed directly on the device layer 3404. In some examples, the first interconnect layer 3406 may include lines 3428a and/or vias 3428b, as shown. The lines 3428a of the first interconnect layer 3406 may be coupled with contacts (e.g., the S/D contacts 3424) of the device layer 3404.

A second interconnect layer 3408 (referred to as Metal 2 or "M2") may be formed directly on the first interconnect layer 3406. In some examples, the second interconnect layer 3408 may include vias 3428b to couple the lines 3428a of the second interconnect layer 3408 with the lines 3428a of the first interconnect layer 3406. Although the lines 3428a and the vias 3428b are structurally delineated with a line within each interconnect layer (e.g., within the second interconnect layer 3408) for the sake of clarity, the lines 3428a and the vias 3428b may be structurally and/or materially contiguous (e.g., simultaneously filled during a dual-damascene process) in some examples.

A third interconnect layer 3410 (referred to as Metal 3 or "M3") (and additional interconnect layers, as desired) may be formed in succession on the second interconnect layer 3408 according to similar techniques and/or configurations described in connection with the second interconnect layer 3408 or the first interconnect layer 3406. In some examples, the interconnect layers that are "higher up" in the metallization stack 3419 in the IC device 3400 (i.e., further away from the device layer 3404) may be thicker.

The IC device 3400 may include a solder resist material 3434 (e.g., polyimide or similar material) and one or more conductive contacts 3436 formed on the interconnect layers 3406-3410. In FIG. 34, the conductive contacts 3436 are illustrated as taking the form of bond pads. The conductive contacts 3436 may be electrically coupled with the interconnect structures 3428 and configured to route the electrical signals of the transistor(s) 3440 to other external devices. For example, solder bonds may be formed on the one or more conductive contacts 3436 to mechanically and/or electrically couple a chip including the IC device 3400 with another component (e.g., a circuit board). The IC device 3400 may include additional or alternate structures to route the electrical signals from the interconnect layers 3406-3410; for example, the conductive contacts 3436 may include other analogous features (e.g., posts) that route the electrical signals to external components.

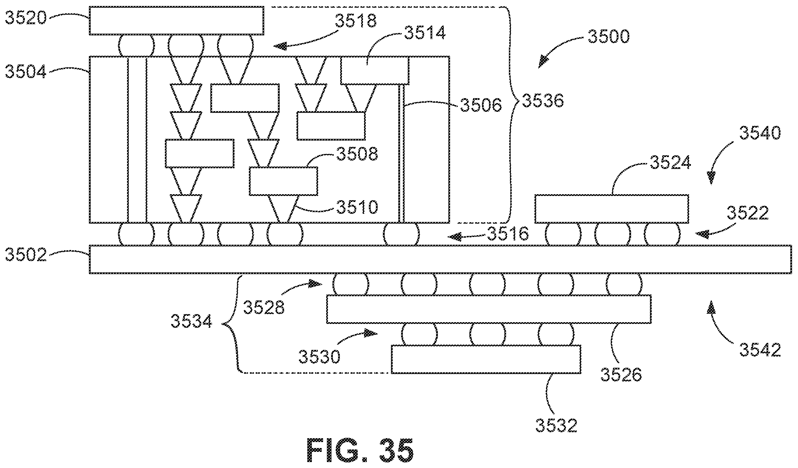

FIG. 35 is a cross-sectional side view of an IC device assembly 3500 that may include any of the examples disclosed herein. In some examples, the IC device assembly corresponds to one of the example IC packages 100, 600, 700, 800, 2404, 2800, 2900, 3000 of FIG. 1-30. The IC device assembly 3500 includes a number of components disposed on a circuit board 3502 (which may be, for example, a motherboard). The IC device assembly 3500 includes components disposed on a first face 3540 of the circuit board 3502 and an opposing second face 3542 of the circuit board 3502; generally, components may be disposed on one or both faces 3540 and 3542. Any of the IC packages discussed below with reference to the IC device assembly 3500 may take the form of the example IC packages 100, 600, 700, 800, 2404, 2800, 2900, 3000 of FIG. 1-30.

In some examples, the circuit board 3502 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 3502. In other examples, the circuit board 3502 may be a non-PCB substrate.

The IC device assembly 3500 illustrated in FIG. 35 includes a package-on-interposer structure 3536 coupled to the first face 3540 of the circuit board 3502 by coupling components 3516. The coupling components 3516 may electrically and mechanically couple the package-on-interposer structure 3536 to the circuit board 3502, and may include solder balls (as shown in FIG. 35), male and female portions of a socket, an adhesive, an underfill material, and/or any other suitable electrical and/or mechanical coupling structure.

The package-on-interposer structure 3536 may include an IC package 3520 coupled to an interposer 3504 by coupling components 3518. The coupling components 3518 may take any suitable form for the application, such as the forms discussed above with reference to the coupling components 3516. Although a single IC package 3520 is shown in FIG. 35, multiple IC packages may be coupled to the interposer 3504; indeed, additional interposers may be coupled to the interposer 3504. The interposer 3504 may provide an intervening substrate used to bridge the circuit board 3502 and the IC package 3520. The IC package 3520 may be or include, for example, a die (the die 3302 of FIG. 33), an IC device (e.g., the IC device 3400 of FIG. 34), or any other suitable component. Generally, the interposer 3504 may spread a connection to a wider pitch or reroute a connection to a different connection. For example, the interposer 3504 may couple the IC package 3520 (e.g., a die) to a set of BGA conductive contacts of the coupling components 3516 for coupling to the circuit board 3502. In the example illustrated in FIG. 35, the IC package 3520 and the circuit board 3502 are attached to opposing sides of the interposer 3504; in other examples, the IC package 3520 and the circuit board 3502 may be attached to a same side of the interposer 3504. In some examples, three or more components may be interconnected by way of the interposer 3504.

In some examples, the interposer 3504 may be formed as a PCB, including multiple metal layers separated from one another by layers of dielectric material and interconnected by electrically conductive vias. In some examples, the interposer 3504 may be formed of an epoxy resin, a fiberglass-reinforced epoxy resin, an epoxy resin with inorganic fillers, a ceramic material, or a polymer material such as polyimide. In some examples, the interposer 3504 may be formed of alternate rigid or flexible materials that may include the same materials described above for use in a semiconductor substrate, such as silicon, germanium, and other group III-V and group IV materials. The interposer 3504 may include metal interconnects 3508 and vias 3510, including but not limited to through-silicon vias (TSVs) 3506. The interposer 3504 may further include embedded devices 3514, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 3504. The package-on-interposer structure 3536 may take the form of any of the package-on-interposer structures known in the art.

The IC device assembly 3500 may include an IC package 3524 coupled to the first face 3540 of the circuit board 3502 by coupling components 3522. The coupling components 3522 may take the form of any of the examples discussed above with reference to the coupling components 3516, and the IC package 3524 may take the form of any of the examples discussed above with reference to the IC package 3520.

The IC device assembly 3500 illustrated in FIG. 35 includes a package-on-package structure 3534 coupled to the second face 3542 of the circuit board 3502 by coupling components 3528. The package-on-package structure 3534 may include a first IC package 3526 and a second IC package 3532 coupled together by coupling components 3530 such that the first IC package 3526 is disposed between the circuit board 3502 and the second IC package 3532. The coupling components 3528, 3530 may take the form of any of the examples of the coupling components 3516 discussed above, and the IC packages 3526, 3532 may take the form of any of the examples of the IC package 3520 discussed above. The package-on-package structure 3534 may be configured in accordance with any of the package-on-package structures known in the art.

FIG. 36 is a block diagram of an example electrical device 3600 that may include one or more of the example IC packages 100, 600, 700, 800, 2404, 2800, 2900, 3000 of FIG. 1-30. For example, any suitable ones of the components of the electrical device 3600 may include one or more of the device assemblies 3500, IC devices 3400, or dies 3302 disclosed herein, and may be arranged in the example IC packages 100, 600, 700, 800, 2404, 2800, 2900, 3000 of FIG. 1-30. A number of components are illustrated in FIG. 36 as included in the electrical device 3600, but any one or more of these components may be omitted or duplicated, as suitable for the application. In some examples, some or all of the components included in the electrical device 3600 may be attached to one or more motherboards. In some examples, some or all of these components are fabricated onto a single system-on-a-chip (SoC) die.

Additionally, in various examples, the electrical device 3600 may not include one or more of the components illustrated in FIG. 36, but the electrical device 3600 may include interface circuitry for coupling to the one or more components. For example, the electrical device 3600 may not include a display 3606, but may include display interface circuitry (e.g., a connector and driver circuitry) to which a display 3606 may be coupled. In another set of examples, the electrical device 3600 may not include an audio input device 3618 (e.g., microphone) or an audio output device 3608 (e.g., a speaker, a headset, earbuds, etc.), but may include audio input or output device interface circuitry (e.g., connectors and supporting circuitry) to which an audio input device 3618 or audio output device 3608 may be coupled.

The electrical device 3600 may include programmable circuitry 3602 (e.g., one or more processing devices). The programmable circuitry 3602 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 3600 may include a memory 3604, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 3604 may include memory that shares a die with the programmable circuitry 3602. This memory may be used as cache memory and may include embedded dynamic random access memory (eDRAM) or spin transfer torque magnetic random access memory (STT-MRAM).

In some examples, the electrical device 3600 may include a communication chip 3612 (e.g., one or more communication chips). For example, the communication chip 3612 may be configured for managing wireless communications for the transfer of data to and from the electrical device 3600. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 3612 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 3612 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 3612 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 3612 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 3612 may operate in accordance with other wireless protocols in other examples. The electrical device 3600 may include an antenna 3622 to facilitate wireless communications and/or to receive other wireless communications (such as AM or FM radio transmissions).

In some examples, the communication chip 3612 may manage wired communications, such as electrical, optical, or any other suitable communication protocols (e.g., the Ethernet). As noted above, the communication chip 3612 may include multiple communication chips. For instance, a first communication chip 3612 may be dedicated to shorter-range wireless communications such as Wi-Fi or Bluetooth, and a second communication chip 3612 may be dedicated to longer-range wireless communications such as global positioning system (GPS), EDGE, GPRS, CDMA, WiMAX, LTE, EV-DO, or others. In some examples, a first communication chip 3612 may be dedicated to wireless communications, and a second communication chip 3612 may be dedicated to wired communications.

The electrical device 3600 may include battery/power circuitry 3614. The battery/power circuitry 3614 may include one or more energy storage devices (e.g., batteries or capacitors) and/or circuitry for coupling components of the electrical device 3600 to an energy source separate from the electrical device 3600 (e.g., AC line power).

The electrical device 3600 may include a display 3606 (or corresponding interface circuitry, as discussed above). The display 3606 may include any visual indicators, such as a heads-up display, a computer monitor, a projector, a touchscreen display, a liquid crystal display (LCD), a light-emitting diode display, or a flat panel display.

The electrical device 3600 may include an audio output device 3608 (or corresponding interface circuitry, as discussed above). The audio output device 3608 may include any device that generates an audible indicator, such as speakers, headsets, or earbuds.

The electrical device 3600 may include an audio input device 3618 (or corresponding interface circuitry, as discussed above). The audio input device 3618 may include any device that generates a signal representative of a sound, such as microphones, microphone arrays, or digital instruments (e.g., instruments having a musical instrument digital interface (MIDI) output).

The electrical device 3600 may include GPS circuitry 3616. The GPS circuitry 3616 may be in communication with a satellite-based system and may receive a location of the electrical device 3600, as known in the art.

The electrical device 3600 may include any other output device 3610 (or corresponding interface circuitry, as discussed above). Examples of the other output device 3610 may include an audio codec, a video codec, a printer, a wired or wireless transmitter for providing information to other devices, or an additional storage device.

The electrical device 3600 may include any other input device 3620 (or corresponding interface circuitry, as discussed above). Examples of the other input device 3620 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 3600 may have any desired form factor, such as a hand-held or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 3600 may be any other electronic device that processes data.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that disaggregate different portions of build-up region(s) of a package substrate from each other and from the substrate core. Disaggregating a build-up region into discrete redistribution blocks in this manner can simplify the fabrication process for each component to reduce the likelihood of defects, thereby improving yield loss. Furthermore, disaggregating the build-up region from the glass core can enable the implementation of certain fabrication processes on the redistribution blocks that would be difficult, if not impossible, if being implemented on an assembly with a glass core due to the fragile nature of glass cores. Further, examples disclosed herein can protect glass cores by embedding them in organic-based structural frames that protect the glass core and enable the core to be handled in processes otherwise limited to organic substrates. While examples disclosed herein provide advantages specific to the implementation of package substrates of glass cores, it should be appreciated that examples disclosed herein are not limited to packages with glass cores. For instance, any of the example redistribution blocks disclosed herein can be used in conjunction with an organic core and/or in any other type of package substrate.

Further examples and combinations thereof include the following:
Example 1 includes a package substrate comprising a glass core having a first side and a second side opposite the first side, a first block of redistribution layers on the first side of the glass core, and a second block of redistribution layers on the first side of the glass core, the first block distinct from the second block.
Example 2 includes the package substrate of example 1, wherein the first block is spaced apart from the second block.
Example 3 includes the package substrate of example 2, further including a filler material between the first block and the second block.
Example 4 includes the package substrate of any one of examples 2 or 3, wherein the first block is laterally adjacent to the second block along the first side of the glass core.
Example 5 includes the package substrate of any one of examples 1-4, wherein first contacts on the first block are electrically coupled to second contacts on the glass core via solder extending from the first contacts to respective ones of the second contacts.
Example 6 includes the package substrate of example 5, wherein third contacts on the second block are electrically coupled to fourth contacts on the glass core via additional solder extending from the third contacts to respective ones of the fourth contacts, the fourth contacts distinct and spaced apart from the second contacts.
Example 7 includes the package substrate of any one of examples 1-6, further including a trace electrically connecting a first interconnect in the first block with a second interconnect in the second block, the trace spaced apart from both the first block and the second block.
Example 8 includes the package substrate of example 7, wherein both the first and second blocks are closer to the glass core than the trace is to the glass core.
Example 9 includes the package substrate of any one of examples 1-8, wherein the first block includes a first glass base, the first glass base fusion bonded to the first side of the glass core.
Example 10 includes the package substrate of example 9, wherein the first block includes a first organic dielectric layer, the first organic dielectric layer defining a first surface of the first block opposite the first glass base, the second block includes a second glass base and a second organic dielectric layer, the second organic dielectric layer defining a second surface of the second block opposite the second glass base, the first organic dielectric layer fusion bonded to the second organic dielectric layer.
Example 11 includes the package substrate of any one of examples 1-10, further including a frame defining a window, the glass core within the window of the frame, the frame including an organic material.
Example 12 includes the package substrate of example 11, further including a mold compound within the window of the frame, the mold compound surrounding the glass core to separate the glass core from the frame.
Example 13 includes the package substrate of any one of examples 11 or 12, wherein at least one of the first block or the second block is within the window of the frame.
Example 14 includes the package substrate of any one of examples 11-13, wherein the frame includes a wall having an inner surface and an outer surface, the window defined by the inner surface, the package substrate further including an electric component embedded in the wall of the frame between the inner surface and the outer surface.
Example 15 includes the package substrate of example 14, wherein the electric component includes at least one of an inductor or a capacitor.
Example 16 includes a package substrate comprising a glass core including through glass vias (TGVs) extending between first and second sides of the glass core, and a block of dielectric material with metal interconnects provided therein, the block connected to the glass core via at least one of (i) solder between contacts associated with the metal interconnects and corresponding ones of the TGVs or (ii) hybrid bonding between a surface of the block and the first side of the glass core.
Example 17 includes the package substrate of example 16, wherein the block is a first block of dielectric material, the package substrate further including an interconnect die embedded in the package substrate, the interconnect die to electrically connect at least one of (i) a first semiconductor chip to be mounted on the package substrate to a second semiconductor chip to be mounted on the package substrate, (b) the first semiconductor chip to the first block, or (c) the first block to a second block of dielectric material.
Example 18 includes an apparatus comprising a semiconductor die, and a package substrate supporting the semiconductor die, the package substrate including a core, and a plurality of disaggregated redistribution blocks distinct from one another and distinct from the core, the disaggregated redistribution blocks attached to the core.
Example 19 includes the apparatus of example 18, wherein the core is a first glass core, the package substrate further includes a second glass core spaced apart from the first glass core, and the second glass core is at an interface between first and second ones of the disaggregated redistribution blocks.
Example 20 includes the apparatus of any one of examples 18 or 19, further including a layer of dielectric material, a first redistribution block of the plurality of disaggregated redistribution blocks between the core and the layer of dielectric material, a second redistribution block of the plurality of disaggregated redistribution blocks between the core and the layer of dielectric material.
Example 21 includes a package substrate comprising a frame defining an opening, the frame including an organic material, a glass core within the opening, the glass core smaller than the opening such that there is a gap between the glass core and the frame, and a mold compound within the gap between the glass core and the frame.
Example 22 includes the package substrate of example 21, further including an electric component embedded in a wall of the frame.
Example 23 includes the package substrate of example 22, wherein the electric component includes at least one of an inductor or a capacitor.
Example 24 includes the package substrate of any one of examples 21-23, further including a first redistribution block and a second redistribution block, the first redistribution block distinct from the second redistribution block, the first redistribution block on a same side of the glass core as the second redistribution block.
Example 25 includes the package substrate of example 24, wherein the second redistribution block is stacked on the first redistribution block.
Example 26 includes the package substrate of example 24, wherein the second redistribution block is laterally adjacent to the first redistribution block.
Example 27 includes the package substrate of any one of examples 24-26, wherein at least one of the first redistribution block or the second redistribution block is within the opening of the frame, the mold compound to encapsulate the at least one of the first redistribution blocks or the second redistribution block.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A package substrate comprising:
a glass core having a first side and a second side opposite the first side;
a first block of redistribution layers on the first side of the glass core; and
a second block of redistribution layers on the first side of the glass core, the first block distinct from the second block.

2. The package substrate of claim 1, wherein the first block is spaced apart from the second block.

3. The package substrate of claim 2, further including a filler material between the first block and the second block.

4. The package substrate of any one of claims 2-3, wherein the first block is laterally adjacent to the second block along the first side of the glass core.

5. The package substrate of any one of claims 1-4, wherein first contacts on the first block are electrically coupled to second contacts on the glass core via solder extending from the first contacts to respective ones of the second contacts.

6. The package substrate of claim 5, wherein third contacts on the second block are electrically coupled to fourth contacts on the glass core via additional solder extending from the third contacts to respective ones of the fourth contacts, the fourth contacts distinct and spaced apart from the second contacts.

7. The package substrate of any one of claims 1-6, further including a trace electrically connecting a first interconnect in the first block with a second interconnect in the second block, the trace spaced apart from both the first block and the second block.

8. The package substrate of claim 7, wherein both the first and second redistribution blocks are closer to the glass core than the trace is to the glass core.

9. The package substrate of any one of claims 1-8, wherein the first block includes a first glass base, the first glass base fusion bonded to the first side of the glass core.

10. The package substrate of claim 9, wherein the first block includes a first organic dielectric layer, the first organic dielectric layer defining a first surface of the first block opposite the first glass base, the second block includes a second glass base and a second organic dielectric layer, the second organic dielectric layer defining a second surface of the second block opposite the second glass base, the first organic dielectric layer fusion bonded to the second organic dielectric layer.

11. The package substrate of any one of claims 1-10, further including a frame defining a window, the glass core within the window of the frame, the frame including an organic material.

12. The package substrate of claim 11, further including a mold compound within the window of the frame, the mold compound surrounding the glass core to separate the glass core from the frame.

13. The package substrate of any one of claims 11-12, wherein at least one of the first block or the second block is within the window of the frame.

14. The package substrate of any one of claims 11-13, wherein the frame includes a wall having an inner surface and an outer surface, the window defined by the inner surface, the package substrate further including an electric component embedded in the wall of the frame between the inner surface and the outer surface.

15. The package substrate of claim 14, wherein the electric component includes at least one of an inductor or a capacitor.
